(19) Europäisches Patentamt
European Patent Office
Office européen des brevets

(11) EP 1 302 767 A1

(12) **EUROPEAN PATENT APPLICATION**
published in accordance with Art. 158(3) EPC

(43) Date of publication:
**16.04.2003 Bulletin 2003/16**

(21) Application number: **01934391.2**

(22) Date of filing: **29.05.2001**

(51) Int Cl.[7]: **G01N 24/10**, G01N 1/02

(86) International application number:
**PCT/JP01/04506**

(87) International publication number:
**WO 01/092862 (06.12.2001 Gazette 2001/49)**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **29.05.2000 JP 2000158797**

(71) Applicant: **Cosmo Ace Co.**
**Hiroshima-shi, Hiroshima 731-01 (JP)**

(72) Inventors:
- **NISHIMOTO, Tetsurou, COSMO ACE CO.**
**Hiroshima-shi, Hiroshima 731-0138 (JP)**
- **KOHNO, Masahiro**
**Hachiouji-shi, Tokyo 192-0073 (JP)**

(74) Representative: **VOSSIUS & PARTNER**
**Siebertstrasse 4**
**81675 München (DE)**

(54) **METHOD FOR DETERMINING SUSPENDED PARTICULATE MATTER, SAMPLING TUBE AND SAMPLING KIT FOR USE IN DETERMINING SUSPENDED PARTICULATE MATTER**

(57) The present invention provides a method for determining suspended particulate matter accurately and conveniently, a sampling tube for sampling the suspended particulate matter, and a sampling kit for using the collection of the suspended particulate materials.

In the present invention, the exhaust emission is passed through a collection material to adsorb the suspended particulate matter in the exhaust emission on it. Then, the amounts of the atoms or the molecular species having unpaired electrons contained in the suspended particulate matter adsorbed on the collection material are determined by using Electron Spin Resonance spectroscopy. The amounts of the suspended particulate matter contained in the exhaust emission may be accurately and conveniently obtained, based on the amounts of the atoms or the molecular species determined above.

Fig. 1

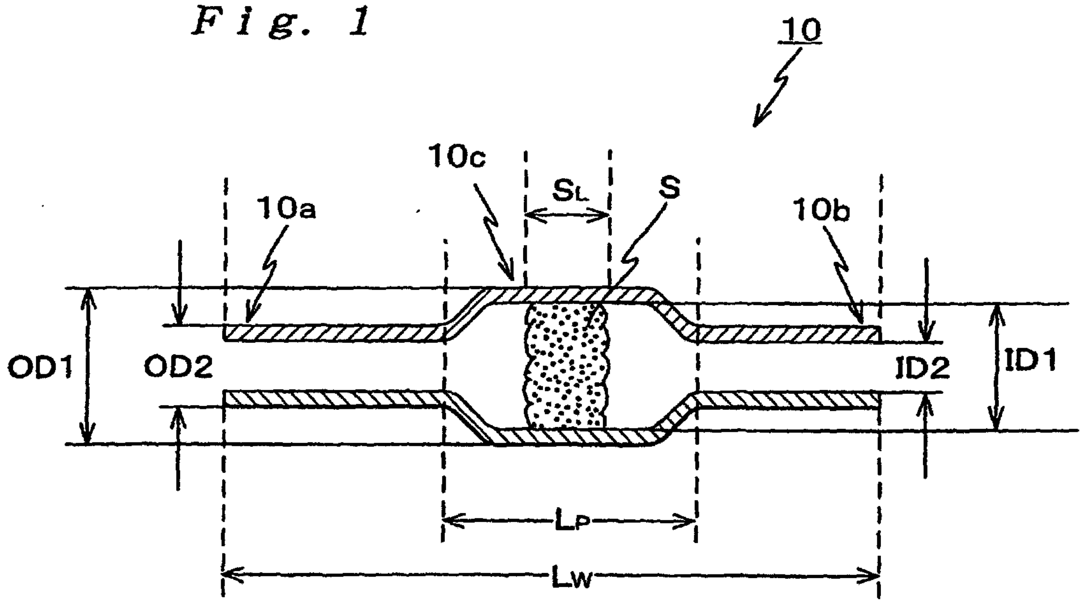


EP 1 302 767 A1

## Description

### *TECHNICAL FIELD*

The present invention relates to a method for determining the amount of particulate matter in gasses, which include suspended dust, aerosol and so forth, referred to as "PM"; a sampling tube for determining thereof; and a sampling kit for determining the amount of particulate matter.

Particularly, the present invention relates to the method for quantitatively determining the amount of the particulate matter having diameter equal to or less than 10 µm, referred to as "SPM" among PM by using Electron Spin Resonance, which is referred to as ESR, Spectroscopy hereinafter; the sampling tube for determining thereof; and the sampling kit for performing the determination. SPM is contained in the exhaust emission, for example, from movable or fixed emission sources in which diesel-powered engine fuel is used.

### *BACKGROUND ART*

Many substances which cause air pollution are known, for example, the sulfur oxides, nitrogen oxides, carbon monoxide, suspended particulate matter, carbon dioxide, and volatile organic compounds and the like.

Air pollution has been a primary contributor of environmental pollution since $40^{th}$ of Showa, and environmental and emission standards have been established to prevent the environment from being. To reduce pollution, many restrictions for controlling the emission of pollutants are enforced. As a result, under these restrictions, for example, focusing on the pollutant, sulfur oxides, the following measures are taken to decrease the level of sulfur oxides in the air: importing crude oil with lower sulfur content, developing techniques for desulferizing the crude oil, and utilizing the devices for desulferizing the exhaust emission, and so forth. Thus, the average level of sulfur dioxides per year has been decreasing steadily. On the other hand, focusing on nitrogen oxides, the total amount of nitrogen oxides is restricted under the standard, and utilizing the devices for denitrogenizing the exhaust emission is promoted. Therefore, the emission of the nitrogen oxides from fixed emission sources, for example, factories are decreasing.

However, exhaust emission from movable emission sources; i.e. vehicles, includes many substances as described above other than nitrogen oxides. Further to the exhaust emission, the restriction for such substances are strengthened, but the levels for the substances allowed by the standards are actually a very low ratio, and this is a serious problem.

The components included in exhaust emission from vehicles vary depending on fuels used. However, recently exhaust emission from diesel-powered vehicles is the focus of attention of exhausted emission issues.

Commercially available diesel fuel is classified into four classes: diesel fuel (general), diesel fuel No.1, No. 2 and No.4, with their composition being almost the same, other than additives included in them. The exhaust emission from such diesel-powered vehicles that consume diesel fuels is composed of a gas phase and a particulate phase. The exhaust emission from diesel-powered vehicles is characterized in that it contains suspended particulate matter at a high concentration, about 20 times higher compared to that from vehicles using gasoline fuel.

According to the conventional analysis method, it is clarified that particulate matter is composed of carbon atoms, organic compounds generated from fuel or lubricants which are adsorbed on the carbon, sulfur oxides generated from a sulfur component included in the fuel, and metal components in trace amounts (see, WHO diesel fuel and exhausted substances, translated by Environment Health Saving Section of Japanese Ministry of the Environment, 1999). Alternatively, it is known that particulate matter exists mostly as particles, of which sizes are in the range between 0.02 µm and 0.5 µm in diameter; but they form aggregates depending on the time, with the maximum diameter of the aggregate reaching 30 µm.

Among these particulate matters, SPM, which is defined as particles suspended in the air and having diameters less than 10µm, stays in the air for a long time. SPM particles deposit on the surface of the lung or the trachea, when they are inhaled through nose or mouth at high concentrations, so that they can increase the probability of respiratory disease. Therefore, their affection to the human body becomes an issue. As the emission source of SPM, there is an artificial one caused by, for example, soot and smoke and dust emitted from factories or incinerators and dust in the exhaust emission from vehicles, particularly diesel-powered vehicles; and a spontaneous one caused by dried soil which is stirred up by the wind, the eruption smoke from the volcano, and so forth.

Among them, in reference to the artificially generated SPM, many things, for example, the components or the formation mechanism from various emission sources and so forth, have been not clarified even as of now.

In order to clarify the effect of SPM, it is necessary to determine the concentration of SPM in the air. As the standard determination method for the particulate matter in the air, so-called mass concentration determination method is employed: wherein the method has the steps of eliminating the particulate matter of which the diameter is larger than 10 µm, collecting the particulate matter of which the diameter is not larger than 10 µm by filtrating, and representing the mass of the matter by dividing the volume of the air aspirated as $mg/cm^3$. According to the method based on the

Environmental Standard under The Basic Environmental Law or Procedure for Emergency Case under Air Pollution Control Law of Japan, it is provided that one of the following methods selected from the group consisting of the light scattering method, the piezoelectric balance method, andβ-ray absorption method should be employed. This is noted in the Notice from Ministry of the Environment No. 25 in 1973 and in the article 18 of Regulation under the Air Pollution Control Law of Japan.

At present, automatic measuring devices are used for continuously monitoring the air pollution. Among them, the device employing β-ray absorption method has been adopted widely.

The environmental standard of SPM provides that the average level of SPM per day is not more than 0.10 mg/$cm^3$, and that per 1 hour it is not more than 0.20 mg/ $cm^3$ by the Notice from Ministry of the Environment on May 8, 1973 under the article 9 of Basic Environmental Law of Japan.
β-Ray absorption method utilizes the principle that the amounts of absorbed light increase in proportion to the amounts of the substance when the β-ray with low energy is irradiated onto the substance.

The automatic measuring device makes determinations by using the steps of irradiating β-ray on particulate matter collected on filter paper, and measuring the transmitted intensity of the β-ray to determine the amounts of the suspended particulate matter. As the β-ray source, a ray source of which dose is not more than 3.7 MBq (100 μCi) of promethium 147 ($^{147}Pm$, its half life is 2.623 years, and its maximum energy is 0.225 MeV) or carbon 14 ($^{14}C$, its half life is 5730 years, and its maximum energy is 0.156 MeV) is used.

The relation between the transmitted intensity of β-ray and the mass of the particulate matter collected is represented as the below equation. In this equation, since the mass absorption coefficient $\mu_m$ is considered as almost constant in spite of the composition of the particles, $X_m$ may be obtained based on the ratio of $I$ and $I_0$.

$$Ln\ (I_0/I) = \mu_m \cdot X_m$$

$I$ : β-ray intensity transmitted to both the filter paper and the particulate matter collected on it
$I_0$ : β-ray intensity transmitted to the filter paper
$\mu_m$: the mass absorption coefficient (g/$cm^2$)
$X_m$: the mass of the particulate matter (g/$cm^2$)

β-ray is absorbed by several members such as the protection membrane for protecting the ray source unit, the filter paper to collect the particulate matter, and the protection membrane for protecting the detection unit to be placed between the ray source and the detector. Therefore, the intensity of β-ray varies depending on the absorbed amounts of β-ray by these members. In β-ray absorption method, only 1 % of the variation that is generated from the β-ray absorption is detected, so that the problem of accuracy in the detection arises.

Alternatively, in the light scattering method, the amounts of the particulate matter are obtained by the following steps: irradiating with the light of a certain wavelength the particulate matter adsorbed on the filter paper, measuring the amount of the light scattered by them, and calculating the difference between the amounts of the irradiated light and the amount of the scattered light as the amount of the light absorbed by the particulate matter to obtain the amount of the particulate matter. Therefore, the accuracy of the determination of the light scattered method varies depending on that of the measured amount of the light scattered.

In the piezoelectric balance method, the amounts of the particulate matter are obtained by the following steps: weighing the mass of the filter paper before use and total mass of the filter paper on which the particulate matter is collected, and obtaining the mass of the particulate matter as the difference between the weights. Therefore, in the piezoelectric balance method, the mass of the particulate matter can be determined accurately if the particulate matter is solely adsorbed on the filter paper. Accordingly, there are issues of the accurate determination in both the light scattered method and the piezoelectric method.

Among exhaust gasses, the exhaust emission from vehicles is defined as "substances such as carbon monoxide, hydrocarbons, lead and other materials derived from driving a vehicle, wherein a vehicle is defined in the Prime Minister's Office Order among the automobiles being provided under Article 2(2) of the Law No. 185 of Road Driving vehicles effective in 1951 and a motorcycle, of which exhaust volume is not larger than 50 cc, is defined under Article 2(3) of the Law, and is deemed to be damaging to human health or the living environment, that being provided for in a Cabinet Order ", according to the Article 2(10) of the Air Pollution Control Law established as Law No. 97 on June 10, 1968 in Japan. The terms "substances being provided for in the Cabinet Order" is defined as carbon monoxide, hydrocarbons, lead compounds, nitrogen oxides, particulate matter" by the Enforcement Order of Air Pollution Control Law, effective in 1968 as Law No. 329.

The content of particulate matter in the exhaust emission from vehicles described above are larger than those in the exhaust emission from diesel-powered vehicle. Since particulate matter is a mixture of carbon, nitrogen, oxygen, and sulfur as major components, they are generally detected by the procedure of Soxhlet's extraction, purification of the extracts, and fractionation of the crude purifications, followed by detection by using gas chromatography combined

with high performance liquid chromatography or mass spectrometry (GC-MS). Accordingly, if a substance that is not extracted or is very slightly extracted is contained in the particulate matter, the substance cannot be detected by using the conventional method.

Since the main point of the control for the exhaust emission was conventionally focused into nitrogen oxides, which is referred to as $NO_x$ below, or sulfur oxides, which is referred to as $SO_x$, the convenient and accurate method for obtaining the amount of the suspended particulate matter emitted has not been established even as of now.

At present, the amount of the suspended particulate matter emitted from vehicles as the movable emission source are determined by using two analysis methods: one is Orsat analysis employed by the Japanese Ministry of the Environment, and the other is the diesel smoke test employed by the Japanese Ministry of Land, Infrastructure, and Transport.

Orsat analysis comprises the steps of blowing a certain volume of the exhaust emission onto filter paper, by using a pump, to adsorb suspended particulate matter in the gas on the paper, weighing the filter paper, and determining the amounts of the suspended particulate matter in the exhaust emission by the increase in the filter paper weight. Since the weight of the filter paper varies depending on the flow of the exhaust emission, humidity in the air, and so forth, an accurate determination of them is difficult.

In the diesel smoke test, analysis comprises the steps of blowing exhaust emission for very short time, 1.4 seconds, on filter paper to adsorb the particulate matter on it, irradiating with light of a certain wavelength the filter paper on which the particulate matter are adsorbed to reflect the light, receiving the reflected light by using a selenium cell to generate a current, and representing the concentration of the suspended particulate matter in the exhaust emission as the current. In this method, the exhaust emission is blown a very short time and the accuracy of the analysis is low. Therefore, there is a problem that it is difficult to determine the amounts precisely.

Accordingly, there is a need to improve fuel, and gas oil to prevent environmental pollution, to develop the diesel-powered engine to generate less amounts of SPM emission or SPM eliminating apparatus and so forth. In order to develop them, it is expected to establish the method for directly analyzing the suspended particulate matter collected with high sensitivity.

## *DISCLOSURE OF INVENTION*

The present invention is completed to solve the problems and issues as described above.

The one feature of the present invention is a method for determining the suspended particulate matter in gas having the steps of (1) passing the gas containing the suspended particulate matter through a sampling tube to adsorb them on a collection material, (2) determining the amounts of atoms or chemical species having an unpaired electron which are contained in the suspended particulate matter adsorbed on the collection material by using Electron Spin Resonance Spectroscopy, (3) obtaining the amounts of the suspended particulate matter in the gas based on the determined amounts of atoms or chemical species having the unpaired electron.

The atom having the unpaired electron is preferably selected from the group consisting of carbon, nitrogen, oxygen, sulfur, copper, iron, manganese, and vanadium. The chemical species having unpaired electron are preferably a radical containing a metallic element or the atom selected from the group consisting of carbon, nitrogen, oxygen, and sulfur. The radical containing carbon atom is generated from fossil fuel or wood by heating and combusting them.

Another feature of the present invention is a sampling tube for quantitatively determining suspended particulate matter by using Electron Spin Resonance Spectroscopy, wherein the tube comprises a body having a neck at both ends wherein the neck diameters are smaller than that of the body and a collection material is contained in the body. An outer diameter of the body is 4 to 25 mm, those of the necks are 3 to 23 mm, and the thickness of the collection material contained in the body is 2 to 40 mm, and an entire length of the tube is 4 to 200 mm. The sampling tube is preferably made of glass or plastic. The glass is preferably quartz glass that contains fewer amounts of impurities, and the plastic is preferably selected from the group consisting of polyethylene, polypropylene, 1,4-polybutene, and polymethyl methacrylate.

The collection material contained in the sampling tube of the present invention is made of a material having adsorption ability or sorption ability. The material is preferably selected from the group consisting of papers, woven and non-woven fabrics, cellulose, glass wool and cotton wool, or their combination.

Still another feature of the present invention is a sampling kit for determining the suspended particulate matter in the gas comprising the sampling tube, and a connection member connecting the sampling tube to tubes for introducing the gas of the interest into the tube. The sampling kit preferably comprises at least two of the connection members and at least two of the sampling tubes.

Furthermore, the connection member is preferably made of heat resistant elastomer, and more preferably the elastomer is selected from the group consisting of silicone rubber, acrylic rubber, ethylene-propylene rubber, chloroprene rubber, styrene-butadiene rubber, and butyl rubber.

Still another feature of the present invention is the sampling kit for determining the amounts of the suspended

particulate matter, which further comprises a container to house the sampling tube and the connection member.

### *BRIEF DESCRIPTION OF THE DRAWINGS*

Fig. 1 is a schematic view showing the sampling tube of the present invention;
Fig. 2 is a schematic view showing the sampling of the gas by using the sampling tube of the present invention;
Fig. 3 is a graph showing the relationship between the ratio of radii of PM particles and the ratio of the signal intensity of ESR;
Fig. 4 is a spectrum of ESR in which the carbon radical was detected;
Fig. 5 is a graph showing relationship between the amounts of the particulate matter and those of the radical;
Fig. 6 is an ESR spectrum of the exhaust emission that was sampled from a track of which capacity tonnage is 3 t produced by A company;
Fig. 7 is an ESR spectrum of the exhaust emission that was sampled from a track of which capacity tonnage is 2.5 t produced by B company;
Fig. 8 is an ESR spectrum of the exhaust emission that was sampled from the track of which capacity tonnage is 3.5 t produced by B company;
Fig. 9 is an ESR spectrum of the exhaust emission that was sampled from the track of which capacity tonnage is 2 t produced by C company;
Fig. 10 is an ESR spectrum of the exhaust emission that was sampled from the station wagon of which capacity tonnage is 1.25 t produced by D company;
Fig. 11 is an ESR spectrum of substances that were deposited inner surface of a muffler or tail pipe attached to the station wagon of which capacity tonnage is 1.25 t produced by D company;
Fig. 12 is an ESR spectrum of the atmosphere that was sampled from 18 to 19 o'clock at an intersection of Asaminami-ku 1-chome in Hiroshima city;
Fig. 13 is an ESR spectrum of the atmosphere that was sampled from 18 to 19 o'clock at Kogo intersection of Route 2 in Hiroshima city; and
Fig. 14 is an ESR spectrum of the atmosphere that was sampled from 23 to 0 o'clock at Kogo intersection of Route 2 in Hiroshima city.

### *BEST MODE FOR CARRYING OUT THE INVENTION*

The present invention is described in detail herein below.

The one feature of the present invention is a method for determining the suspended particulate matter in a gas comprising the steps of (1) passing the gas containing the suspended particulate matter through a sampling tube to adsorb them on a collection material, (2) determining the amount of atoms or chemical species having an unpaired electron which are contained in the suspended particulate matter adsorbed on the collection material by using Electron Spin Resonance Spectroscopy, and (3) obtaining the amount of the suspended particulate matter in the gas based on the determined amount of atoms or chemical species having the unpaired electron.

In the method of the present invention, the atom having an unpaired electron collected on the collection material is selected from the group consisting of iron, copper, vanadium, manganese, cobalt, chromium, titanium, and molybdenum.

As the chemical species having an unpaired electron, a radical comprising carbon atom or metallic atom is preferable. More preferably, there can be mentioned, for example, a hydrocarbon radical derived from alkane or alkene, hydrocarbon radicals with a linear chain such as methyl radical, ethyl radical, a radical derived from saturated or unsaturated fatty acids; hydrocarbon radical with a branched chain such as tris(pentachloro phenyl)methyl radical, triphenyl methane; radicals derived from polycyclic aromatic compounds represented by anthracene, naphtharene, benzopyrene, and so forth; and the radicals from the compounds comprising divalent manganese ion ($Mn^{2+}$), divalent copper ion ($Cu^{2+}$), trivalent iron ion ($Fe^{3+}$), trivalent or pentavalent chromium ion ($Cr^{3+}$, $Cr^{5+}$), divalent or tetravalent vanadium ion ($V^{2+}$, $V^{4+}$), and so forth.

The atom having an unpaired electron or the radical comprising carbon, nitrogen, oxygen, sulfur or metallic atom is generated by heating and combusting the wood or fossil fuel such as petroleum, coal, and so forth. Particularly, the metallic atom, which is so-called heavy metal, includes iron, copper, manganese, and chromium, is rich in oil fuel. Such metallic atoms generate corresponding radicals when the oil fuel is burned, so that the amounts of PM or SPM in the gas may be quantitatively determined by using the radicals as an index.

Alternatively, when the heavy metal atom described above or aluminum atom are detected in exhaust emission, even though fuel with a low content of the heavy metal atoms is used but the heavy metal or aluminum is detected,

the result may be used in the index showing, for example, for estimating the status of the catalyst for treating the exhaust emission from the vehicle or for evaluating the performance of the engine. In the catalyst for treating the emission gas, divanadium pentaoxide ($V_2O_5$) or rhodium (Rh) is held on the catalyst carrier metal such as aluminum, which provides the scaffold for the catalyst metal. Therefore, the detection of the above-mentioned metal seems to show that the catalyst is damaged for some reason and they are emitted from the muffler or tail pipe of a vehicle with such gas.

In the present invention, the sampling tube for quantitatively determining the suspended particulate matter by using the Electron Spin Resonance Spectroscopy comprises the body, necks formed at both ends of the body of which diameters are smaller than that of the body, and the collection material contained in the body. The outer diameter of the body is 4 to 25 mm, that of the neck is 3 to 23 mm, the thickness of the collection material contained in the body is 2 to 40 mm, and the entire length of the tube is 27 to 200 mm. The reason for seize of the tube defined above is described below.

In order to determine SPM by using ESR Spectroscopy, the sampling tube needs at least about 0.15 to 4.8 $mm^3$ of the effective volume for the determination. Conventionally, when the solid sample is measured by using an ESR apparatus, a certain amount of the sample, for example, 200 mg, is precisely weighed by using a balance, for example, an electrical balance; and then, the weighed sample is transferred into a round-bottomed glass tube for the ESR spectroscopy and measured. The size of the glass tube is provided for the resonator comprised in the ESR apparatus, when the line width of the signal becomes narrow. In the ESR apparatus produced by JEOL Ltd., a tube having an inner diameter (i. d.) 4 mm/ outer diameter (o. d.) 5 mm, and the entire length of the tube being 27 to 100 mm is used. In the ESR apparatus produced by Bruker Bio Spin GmbH, the round-bottomed tube of which i. d. 3 mm/ o. d. 4 mm, and the entire length of 27 to 100 mm is used. Since the world market share of these two companies is high, the above-mentioned size of glass tube for measuring is de facto standard. However, in the above-mentioned size of glass tube, the effective measurement range is about 25 to 40mm, in terms of the effective volume for the measurement, 0.15 to 4.8 $mm^3$. Therefore, modifications are necessary to perform more sensitive measurement by using an ESR apparatus.

In order to observe the electron spin state of the metallic atom by using the ESR apparatus, high resolution is needed for the magnetic field of the apparatus. However, since the line width of the ESR signal is wide when PM or SPM is determined, high resolution is not needed in the magnetic field. It means that there is no restriction for the determination of them so that the size of the sampling tube is decided as described below.

Accordingly, considering the amounts of the SPM for sampling and the accuracy for the determination of SPM, the size of the sampling tube is as follows: o. d. of the body is 4 to 25 mm, o. d. of the necks is 3 to 23 mm, the entire length of the tube is 27 to 200 mm. Furthermore, the tube contains the collection material of which thickness is 2 to 40 mm. Since the sampling tube used in the present invention is composed of the material having uniform thickness, the inner diameters of the body and the necks are about 1 mm smaller than the outer diameters. One of the necks is connected to the pump through a gas exhaust tube so that the inner diameters of the neck are in the range in which the collection material contained in the body does not slip off.

As a result, in the sampling tube for quantitative determination of the present invention, o. d. of the body is preferably 5 to 20 mm, o. d. of the necks is preferably 4 to 1 mm, and the entire length of the tube is preferably 35 to 150 mm. More preferably, o. d. of the body is 6 to 15 mm, o. d. of the necks is 5 to 11 mm, and the entire length is 38 to 120 mm. Based on the amounts to be collected in the suspended particulate matter, the size of the tube is applied to ESR apparatus currently used when o. d. of the body is about 9 to about 11 mm, o. d. of the necks is about 6 to about 10 mm, the entire length of the tube is about 40 to about 50 mm with no problem.

According to use the sampling tube having the above-mentioned size containing the collection material, a sample of the necessary amounts for determination can be collected easily. Then, determination after sampling is performed accurately. Furthermore, the present invention does not need the weighing of a certain amount of sample collected to transfer into the sample tube, which is necessary in the conventional method, and the sampling tube of the present invention may be directly subjected to the determination by using an ESR apparatus. Therefore, the step for weighing a certain amount of the sample collected can be skipped so that the present invention has the advantage to avoid the measurement error caused by weighing.

The sampling tube is preferably made of glass or plastic. As the glass, there can be mentioned, for example, the soft glass such as soda-lime glass, lime glass, and quartz glass; and the hard glass which are obtained by replacing the sodium components in the soft glass with almina. As the plastic, there can be mentioned, for example, aliphatic hydrocarbons which may have branched chains such as polyethylene, polypropylene, polybutene and so forth; unsaturated polyesters such as poly(ethylene terephthalate), poly(butylenes terephthalate) and so forth; EVAL (trademark of Kuraray Co. Ltd.), 1,4- polybutene, methyl methacrylate, and so forth. The glass or plastic described above are preferably used because they can easily processed and the cost is not high.

Among them, a cell for the determination, the sampling tube formed by using the quartz glass, polyethylene, polypropylene or methyl methacrylate, is suitable to determine the amounts of PM and SPM in the gas, particularly the

exhaust emission, because such materials never gives signals which overlap that given by radicals from heavy metals contained in the gas. When the sampling tube is made of quartz glass, the metallic radicals such as iron ions, copper ions, vanadium ions and so forth are detected with high sensitivity.

The collection materials employed in the above-mentioned sampling tube are preferable composed of the material that has the adsorption ability or sorption ability. "Adsorption" is defined as the concentration of molecules or ions at the outside and becomes higher than that of the inside when the interface is formed between two phases. "Sorption" is defined as the phenomenon in which the adsorption and absorption occurs simultaneously; this phenomenon is observed when molecules of gasses or solutes are adsorbed into the interface between the solid-gas or solid-liquid, followed by the absorption of adsorbate into the inside of the solid.

As the material having the adsorption ability or sorption ability, there can be mentioned many things such as papers, woven and non-woven fabrics and so forth. However, in the present invention, it is necessary to employ those having some degree of air permeability and it does not give or hardly gives a signal that overlaps that from the chemical species or molecular species of interest by using ESR apparatus. Therefore, it is preferable to employ a paper such as ordinary paper or Japanese paper called Washi; fibers such as polyester, nylon, acryl, cellulose, glass wool, cotton, silk, linen or the woven or non-woven fabric made from them; the cotton wool, which is processed from cotton; silica sand, and so forth.

The above-mentioned materials can be used alone or in combination. The fibers described above may be either long ones or short ones, and any fiber can be employed if it can be packed into the body of the tube as the collection material and it does not slip off when the pump connected to the sampling tube through the exhaust tube is in operation. Furthermore, if there are chemical species to be detected in high sensitivity, the collection material that gives the signals which does not overlap those from the chemical species may be selected.

Among the collection materials as described above, cellulose and cotton wool may be most preferably used, because they do not give unnecessary signals in the determination by using ESR.

The sampling tube and the collection material of the present invention sometimes need a certain degree of heat resistance. For example, when PM or SPM in the exhaust emission from a diesel-powered vehicle is determined, it is necessary for the accurate determination of PM or SPM to use the material to be resistant to temperatures more than 80 °C, for about 10 hours, because the exhaust emission has a high temperature. For such determination, the sampling tube is preferably made of quartz glass or heat resistant plastic, and the collection material is preferably composed of glass wool or cotton wool.

The sampling kit for quantitatively determining the suspended particulate matter in the gas comprises the sampling tube described above, and connection members one of which connects the sampling tube to tubes for introducing the gas of interest into the tube, and the other connects the sampling tube to an exhaust tube for exhausting the gas after the sampling is finished. The gas is introduced into the sampling tube through the introduction tube and exhausted through the exhaust tube, and the sampling of the gas is performed when the gas passes through the sampling tube. Therefore, the sampling kit of the present invention preferably comprises at least two connecting members and at least two sampling tubes. For one sampling, one of the sampling tubes contained in the sampling kit is used.

The connection member is preferably made of a heat resistant elastomer. The "heat resistant elastomer" is defined such that the form and the physical properties of the elastomer are not changed even though it is exposed to temperatures more than 80 °C for about 10 hours. Among elastomers, which is the general name of synthetic rubbers and elastomeric plastics, for example, low-density polyethylene, non-rigid PVC and the like are used. When the sampling is performed at a place close to an intersection having a large traffic capacity, since the temperature of the gas is almost the same as that of the air, the connection member made of the elastomer for general purposes can be employed.

As the connection member, there can be mentioned that those made of isoprene rubber, polyurethane, silicone rubber, acrylic rubber, ethylene-propylene rubber, chloroprene rubber, styrene-butadiene rubber, butyl rubber and so forth are used.

When the exhaust emission is sampled directly from the outlet of the muffler or tail pipe of the vehicle, the temperature of the emission reaches the range of about 60 to 250 °C so that the connection member made of the heat resistant elastomer as described above must be used. As the heat resistant elastomer, there can be mentioned such as silicone rubber, acrylic rubber, ethylene-propylene rubber, chloroprene rubber, styrene-butadiene rubber, butyl rubber and so forth, and the silicone rubber is preferably used because it can be purchased easily and the cost is low.

The sampling kit for quantitatively determining the amounts of the suspended particulate matter of the present invention may further comprise the container to house the above-mentioned sampling tube and connection members. The container maintains the sampling tubes before use to prevent damage by housing, and keeps the sampling tubes with the necessary information after sampling safely, preventing damage, until they are subjected to the determination by using ESR.

The shape of the container itself, the shape and the material of the member for fastening the sampling tube described above are not limited, if they can be maintained safely when the sampling tube is carried. For example, the

commercially available polyurethane foam or polystyrene foam may be cut so as to be a proper size to be housed in the container, and form grooves to insert the sampling tube in the foam, and may be housed in container with a lid, for example, made of polypropylene. The lid and the container may be connected through hinges, if it is produced as the monolithic one.

In the above-mentioned method, in order to quantitatively determine the amounts of the atoms or chemical species having an unpaired electron, which are referred to as radicals below, contained in the suspended particulate matter, the collection material is preferably that having the adsorption ability or sorption ability and air permeability, and it does not affect the ESR spectroscopy. In ESR spectroscopy, since each signal given by radicals is clarified to a certain degree, the material gives the signal which does not overlap to that from the radical may be selected, when the radicals to be detected are focused.

As the collection material described above, concretely, the papers, the woven and non-woven fabrics, cellulose, graphite cellulose, glass wool, a filter paper made of glass wool, zeolite and modified thereof, and cotton wool, and so forth are used.

Among these collection materials, cellulose or cotton wool is most preferable, because they do not give any signal in ESR spectroscopy.

The paper used as the collection material may be ordinary paper or special Japanese paper, not limited if it has porosity through which the components of the gas can pass. However, commercially available filter paper is preferable because the pore size is well controlled. By using filter paper with the pore size in the suitable range, SPM having the desirable diameter of the particle may be collected.

As these filter papers, there can be mentioned, for example, that having 3 to 25 μm of the sustainability of the particle provided by Whatman PLC, and the like. In order to determine the amount of the finer suspended particulate matter, they can be effectively collected by using the filter paper made of glass fiber with sustainability of a particle 1 to 3 μm. The filter to be used for the determination depends on the application of the determination.

In general, the woven and non-woven fabrics contain the woven fabrics, the non-woven fabrics and knitted fabric, and they may be either composed of natural fibers or synthetic fibers, if they have the heat resistance and the air permeability as described above. Accordingly, there can be mentioned natural fibers comprising those from plants such as cotton and linen or those from animals such as silk and wool, synthetic fiber such as polyimide, ceramic fiber such as glass fiber or carbon fiber, and so forth. It is preferable to use the polyimide, glass fiber, carbon fiber, and so forth, considering the heat resistance.

Cellulose is one of simple polysaccharides, and is the main component of higher plants, the cellular membrane or the fiber of algae. Cellulose is hydrolyzed with acids, however, it is insoluble in water and highly resistant to chemicals. In general, it is obtained from woods, cotton or linen in industry.

Pretreatment for ESR spectroscopy is not necessary, when graphite cellulose, which is a porous material carbonized by heating cellulose, or mordenite, of which components are the same as zeolite but the shape of the pore is different, is used.

Cotton wool is defined as sanitary goods produced from cotton, which is given water-absorbing ability and then sterilized. Except the commercially available cotton wool, purified cotton wool is listed in the Japanese Pharmacopoeia.

The sampling tube shown in Fig. 1 is produced as described herein. For example, a tube made of glass having o. d. (OD1) 10 mm, of which i.d. (ID1) 8 mm, is cut off by using a cutter for glass so as to make the length about 150 mm. Then, the cut off one end of the glass tube is heated by a burner to be extended to form a neck part having o. d. (OD2) of 6 to 8 mm, of which i. d. (ID2) is 4 to 6 mm. From the other end, 10 to 200 mg of the collection material is uniformly packed to a thickness ($S_L$) of about 5 mm. When pelletized collection material is used, filter paper having the desirable pore size or glass wool is first packed in the tube, and then the collection material is packed as described above. After that, another filter paper or glass wool is packed into the body. According to this, the collection material does not spill off from the tube and its thickness can be maintained uniformly.

Then, the other side, of which side the neck is not formed, is heated by the burner to be extended to form the neck having an i. d. of 6 to 8 mm. After this operation, the sampling tube is cut off to be the entire length of about 40 to 45 mm to prepare the sampling tube for the quantitative determination of the suspended particulate matter. The length of the body ($L_p$) is not limited if the collection material can be packed, however, it is necessary to have a space which protects the collection material from heating when the neck is formed.

The sampling tube in which the exhaust emission passed through for a certain time to collect the components of the emission gas is subjected to ESR spectroscopy, at that time the sampling tube is used as the sample tube for the determination by using ESR. Therefore, the sizes of the sampling tube are limited to $L_W$ of 27 to 200 mm, and OD1 of 4 to 25 mm. When either the sizes of the sampling tube of the present invention are larger or smaller than that described above, the sampling tube cannot be used as the sample tube for the determination by using ESR spectroscopy, and performing convenient and accurate determination by using ESR becomes impossible.

As the sample tube for ESR spectroscopy determination, the tube having the bottom of which o. d. is about

4 to 11 mm, and the entire length is 27 to 100 mm is used.

In ESR spectroscopy, the subjects for the determination are atoms or chemical species having unpaired electrons. The unpaired electron is defined as a single electron belonging to an orbital in an atom or molecule, which it has an odd number of the electrons, or has many orbitals accommodating the electrons so that one of orbitals has one electron. The atoms or chemical species having an unpaired electron are referred to as a free radical or radical, which are generally unstable and hardly isolated. Radicals are generated by the decomposition of molecules caused by heat or light , irradiation of the ray or electron beam, or by using metal reducing, and so forth.

As the atom having the unpaired electron, there can be generally mentioned transition elements, for example, copper, iron, manganese, cobalt, chromium, and vanadium.

In the present invention, among the atoms having unpaired electrons as described above, those having the unpaired electrons of interest are selected from the group consisting of carbon, copper, iron, manganese and vanadium. These unpaired electron are detected in the determination, , and graphite carbon atoms are also detected in the determination. Alternatively, as the chemical species having an unpaired electron, there can be mentioned a carbonated radical derived from alkane or alkene; hydrocarbon radical having the linear chain such as methyl radical, ethyl radical, a radical generated from the saturated or unsaturated fatty acid; and the hydrocarbon radical having the branched chain such as tris(pentachlorophenyl)methyl radical and triphenylmethane, and so forth.

As the aromatic compounds radical generated from the aromatic hydrocarbons, there can be mentioned, for example, anthracene, naphtharene, and benzopyrene, and so forth. As the radical including the metal atom, there can be mentioned, for example, radicals generated from the compounds comprising the metal atom such as divalent manganese ion ($Mn^{2+}$), divalent copper ion ($Cu^{2+}$), trivalent iron ion ($Fe^{3+}$), divalent or tetravalent vanadium ion ($V^{2+}$, $V^{4+}$), trivalent or pentavalent chromium ion ($Cr^{3+}$, $Cr^{5+}$) and the like.

In the present invention, among these radicals, the subject of the determination is the divalent copper ion, trivalent iron ion, divalent or tetravalent vanadium ion, and trivalent or pentavalent chromium ion.

Among the radicals, the radical having the linear chain or the branched chain is generated when fossil fuel or wood is burned and combusted. Fossil fuel means , for example, petroleum products, diesel oil, gasoline, gas oil or coal. These radicals exist in the asphalt obtained by being purified from petroleum or in charcoal, but the radical as the interest of the present invention is contained in the suspended particulate matter in the combustion gas of the fuel such as the gas oil and heavy oil, and so forth.

In diesel-powered vehicles, diesel oil is used as fuel, and the content of the suspended particulate matter in the exhaust emission from it are known to be 10 to 20 times higher than those contained in the exhaust emission from gasoline vehicles, and becomes a problem in that it causes many respiratory diseases.

A sample is taken from exhaust emission from fixed or movable emission sources as follows: Firstly, as shown in Fig. 1, the connection members 11 and 12 are respectively connected to necks 10a and 10b formed on the both ends extended from of the body of a sampling tube 10c. Then, the connection members 11 are respectively connected to tubes 13 and 14 that are made of metal and so forth and having the desirable i. d. and the entire length L. The tube 14 is connected to a pressure hose made of rubber 20, which is connected to a pump P. One end 13a of the tube 13 is set to a place 10 cm inside from the edge of the outlet pipe of the fixed or movable emission source (not shown in the figure). The switch of the pump is turned ON, and it works for a pre-determined time period to pass the exhaust emission through the sampling tube to adsorb or to sorb the suspended particulate matter on a collection material S packed in the sampling tube for sampling.

When the plural set composed of the sampling tube described above and the pump are prepared, a plurality of the samples for the quantitative determination from the one exhaust pipe can be taken.

After sampling, the sampling tube 10 is removed from the connection members 11 to 12, and the amounts of the atoms or the chemical species having an unpaired electron in the suspended particulate matter collected on the collection material are determined by using Electron Spin Resonance spectroscopy, which is referred to as ESR spectroscopy, as described below. Based on the value, the amounts of the suspended particulate matter in the exhaust emission may be obtained.

In the determination of the present invention, an ESR apparatus is used for the determination. ESR spectroscopy is a spectroscopy utilizing an unpaired electron in paramagnetic substances, and it gives the information for an electron state or the circumstance surrounding the electron, and so forth. Therefore, in the determination method of the present invention, the atoms or the chemical species contained in the emission gas, some of which have the unpaired electron but other ones do not have it, are not determined respectively; but the entire amounts of them may be selectively determined without any treatment prior to the determination. Conventionally, Gas Chromatography, which is referred to as "GC", or High Performance Liquid Chromatography, which is referred to as "HPLC" is used to measure the amounts of the chemical species and so forth in the emission gas, but they need the treatment prior to the determination. However, since ESR spectroscopy utilizes completely different principles from GC or HPLC to analyze atoms or chemical species as described above, any treatment prior to the determination is not necessary.

According to the spectrum of ESR, g value which shows the position of the absorbance by the unpaired

electron, the absorption intensity which shows the number of the electron, the absorption width related to the relaxation time, and the hyperfine structure caused by the unpaired electron and the neighborhood nuclear spin or the fine structure caused by the interaction between the electrons are shown, and the following things are given based on it:

(1) the presence or absence of the unpaired electron and the quantitative value of them;
(2) the position of the unpaired electron in the molecule and the state of its circumstances, which shows the radical structure;
(3) the distribution of the density when the unpaired electron is not localized in the molecule, which shows the electron state;
(4) the interaction between the unpaired electrons, in-molecules or inter-molecules; and
(5) the reaction rate or the reaction mechanism based on the time-dependent change of the absorption intensity.

g is a spectroscopic separation coefficient or g value, and $g_e$ of the free electron is 2.002319. β is Bohr magneton and it shows the magnitude as the magnet, 9.274 x $10^{-24}$ J/T (9.274 x $10^{-21}$ erg/gauss), and represented by this equation. g value is the inherent value of the radical independent of the wavelength of the microwave employed in the determination, and it shows the electron state of the radical. Ho means magnetic field.

In the apparatus for ESR spectroscopy, the electromagnetic wave which is in the microwave range correspond to $E_0$ is irradiated to measure the absorbance of the magnetic wave (EM = hν). In the present invention, firstly, the desirable size of the test strip of the sample is cut out from the collection material on which the dust was collected as described above, or a certain amount of the sample is weighed, and then determined by using ESR apparatus under the predetermined conditions to obtain the signal intensity.

Then, the known concentration of the nitroxide radical is determined as a reference standard to obtain the signal intensity. The nitroxide radical is one of a radical represented by the following equation (1), wherein R and R' represent an alkyl group. The ESR spectrum of the nitroxide radical shows triplet caused by the fine coupling generated between the unpaired electron and the electrons of nitrogen.

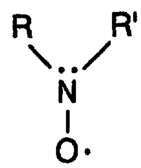

(1)

As these nitroxide radicals, there can be mentioned, for example, TEMPOL (2,2,6,6-tetramethyl-4-pyperidinol-1-oxyl), and so forth.

The determination for the amounts of the atoms or chemical species having the unpaired electron is explained below through examples of the case in which TEMPOL is used as the reference material. A predetermined concentration of TEMPOL solution is prepared, and it is subjected to the determination by using ESR to obtain its spectrum. Subsequently, the atom or the compound having the unpaired electron prepared as described above is subjected to ESR spectroscopy to obtain its spectrum under the same condition as the determination of TEMPOL.

Comparing the signal intensity of TEMPOL to that of the atom or the compound, the amounts of the atom or the compound is obtained based on the concentration of TEMPOL.

According to this, the concentration of the radical in the sample is obtained, and the concentration of the suspended particulate matter is determined based on the ratio of the radical in the suspended particulate matter collected on the collection material.

The atoms and the chemical species having an unpaired electron of interest is similarly to those described above, and the radical is also the same as that described above.

For example, when gas oil is combusted, the amounts of the substance like carbon in the exhaust emission derived from the gas oil varies depending on the condition of the combustion. However, the ratio of the atoms or the chemical species having the unpaired electron generated in the exhaust emission is constant under the same condition. The longer the time for passing the exhaust emission through the collection material, the larger the amounts of both the substance like carbon collected on the collection material and the atoms or the chemical species having the unpaired electron is time-dependent, so that this fact demonstrates that the ratio is constant under the same condition.

Accordingly, it is possible to quantitatively determine the amounts of the suspended particulate matter in the exhaust emission based on the ESR spectrum data, with the relationship between the amounts of the suspended particulate matter collected on the collection material and those of the atoms or the chemical species having the unpaired electron in them.

The determination for the amounts of the suspended particulate matter by using the collection material, which

is directly attached to the muffler or tail pipe of diesel-powered vehicle is explained through the examples below.

As the collection material, cotton fabric is cut into the square pieces about 10 cm by about 10 cm. Then a piece of the fabric is attached to cover the outlet of the muffler or tail pipe and fixed not so as to slip out of the place by using a jig of which diameter is fit to that of the muffler or tail pipe. After that, the engine of the vehicle is started to pass the exhaust emission through the collection material for about 5 minutes, and then the collection material is left on the muffler or tail pipe.

Subsequently, the test strips of which size is 3mm x 40 mm are cut off from the square piece of the collection material for the determination; a sample 1 is taken from the collection material, in which the part of the exhaust emission was passed through, and a sample 2 is taken from that, in which the part of the gas was not passed through. Alternatively, 200 mg of the suspended particulate matter collected on the collection material is weighed as the sample and transferred into the sample tube to be subjected to ESR spectroscopy. On the other hand, a predetermined amount of the benzene or toluene solution of TEMPOL is placed into another sample tube to be used as a reference material to be subjected to ESR spectroscopy.

The concentration of the reference material is prepared in the range between $10^{-3}$ to $10^{-6}$ mol/L. Then, from the ESR spectrum, the relative intensity of the signal of the reference material, the respective relative intensity of the samples 1 and 2 are obtained. Subsequently, the relative intensity of the reference material and those of samples are compared as an area represented on the spectrum to obtain the concentration of the radical. According to this, the amounts of the radicals in the suspended particulate matter collected on the collection material are obtained.

When TEDLAR™ bag is connected to the muffler or tail pipe through the collection material attached to the outlet of the muffler or tail pipe, the amounts of the suspended particulate matter can be determined as those per $m^3$ or L.

***EXAMPLES***

The present invention is explained referring to the following examples, however, the scope of the present invention is not limited to them.

(EXAMPLE 1) The relationship between the signal intensity of ESR and the weight of the standard PM

The standard PM shown in table 1 was obtained from the National Institute of Environmental Studies of Japan. The relationship between the weight of PM and the signal intensity of ESR spectrum was studied.

<Conditions for ESR spectroscopy>

Frequency of the microwave: 9330 [MHz]
Output of the microwave: 4.00[mW]
Field center: 332.85 ± 5 [mT]
MOD frequency: 100 [kHz]
MOD width: 0.5 to 1.0 [mT]
Sweep time: 2.0 [min]
Amplitude: 200.0
Time constant: 0.1 [sec]

The ratio of PM radius in each weight of the standard PM was obtained based on their weight, and checked the relationship between them and the signal intensity of ESR. Results are shown in table 1 and Fig. 3.

Table 1

| PM weight (mg) | The ratio of PM radius | The signal intensity of ESR (x $10^6$) | The ratio of the signal intensity |
|---|---|---|---|
| 5.0 | 1.00 | 366.6 | 1.00 |
| 10.0 | 1.89 | 694.4 | 1.26 |
| 15.0 | 2.53 | 929.5 | 1.44 |
| 20.0 | 2.91 | 1,067.1 | 1.59 |
| 25.0 | 3.51 | 1,288.8 | 1.71 |
| 30.0 | 4.05 | 1,484.4 | 1.82 |

As shown in table 1, it is recognized that there is a positive correlation between the weight of PM and the signal intensity of ESR. Also, it is recognized that there is a positive correlation between the ratio of PM radius and the signal intensity of ESR as shown in Fig. 3.
Accordingly, it is demonstrated that the PM amount in the sample may be obtained from the signal intensity of ESR.

(EXAMPLE 2) Material and methods for determining the PM amount in the exhaust emission

(1) Materials for sampling

As tubes made of glass for the sampling tubes of the present invention, the tubes made of quartz glass having 10 mm for the outer diameter and 8 mm for the inner diameter, were purchased from Labotech Inc. For glass wool, Mat Ace (trademark of the glass fiber produced by Asahi Fiber glass Co.) was used. For cotton wool, mesh size 205 of the cotton wool was purchased from Nisshinnbo Industries, Inc.,
**[0106]** Except the sampling tube, the cotton fabric (width 1 m x length 10 m x thickness 0.08 mm) for collecting both PM and SPM in the exhaust emission from a diesel-powered engine was used from Nitto Boseki Co., Ltd.
(2) As the emission source for the exhaust emission from the diesel-powered vehicle, trucks of which capacity tonnage is 2 t and 3 t produced by A company, trucks of which capacity tonnage is 2.5 t and 3.5 t produced by B company, truck produced by C company, and a station wagon of which capacity tonnage is 1.25 t produced by D company were used. As fuels, gas oil produced by Idemitsu Petrochemical Co., Ltd, Shell Sekiyu K.K., Cosmo Oil Co., Ltd, Esso Inc., and Kyodo Sekiyu K. K. were used. The exhaust emission from each car was sampled after preconditioning 10 minutes prior to traveling test.
(3) The unpaired electron was detected by using ESR (JES-FA200 type, JEOL Ltd.). Benzene and toluene were purchased from Wako Pure Chemical Industries Ltd. As the standard material, TEMPOL was used.

(EXAMPLE 2) Determination by ESR

(1) The cotton fabric was used as the collection material collecting for PM or SPM in the exhaust emission from the diesel-powered vehicle.

The cotton fabric was cut at the size 10 x 10 cm, and single piece was used as the collection material to attached to cover the outlet of the tail pipe of the track, of which capacity tonnage is 2.5 t produced by A company. The piece was fastened tightly by using hose band made of stainless steel having a width of 5 mm. Then the diesel-powered engine was started and driven for 5 minutes as a trial.

(2) Detection of Radicals by ESR

The diesel-powered vehicle is subjected to the traveling test under the condition as mentioned in EXAMPLE 1. When the traveling test was finished, the collection material was removed from the outlet of the muffler. The test strips with the rectangular shape of which size is 5mm x 40 mm, were excised from both the part of the collection material, at which the exhaust emission was passed through, and the part of which exhaust emission was not passed through, by using a stainless steel knife to be subjected to ESR determination (JES-FA200 type, JEOL Ltd.).
Half mL of Benzene solution or toluene solution of TEMPOL was placed into test tubes to use them as the standard material.

<Conditions for ESR measurement>

Frequency of the microwave: 9330 [MHz]
Output of the microwave: 4.00[mW]
Field center: 332.85 ± 5 [mT]
MOD frequency: 100 [kHz]
MOD width: 0.5 to 1.0 [mT]
Sweep time: 2.0 [min]
Amplitude: 200.0
Time constant: 0.1 [sec]

Results of the determination for the strips excised from the cotton through which the exhaust emission passed are shown as Fig. 4. The signal shown in Fig. 4 shows the following ESR parameters: g value is 2.0032, and line width is 0.8 mT. From such ESR parameters, it seems that the signal belongs to a carbon radical or an aromatic carbon radical.
Accordingly, it is demonstrated that either the carbon radical or the aromatic carbon radical existed in the carbon-like substance contained in the suspended fine particles that are generated when the gas oil is combusted. The concentration of the radical is $10^{14}$ to $10^{16}$ spin/sample.
The strips excised from the cotton through which the exhaust emission did not pass are determined as described-above. The results showed that the concentration of the radical is about $10^{13}$ spin/sample. The radical existing in the particulate matter was stable.

(EXAMPLE 3)

Sampling was performed as the same condition as Example 1 except that the preconditioning time of the diesel-powered vehicle is 10 minutes. After the sampling, the collection material was removed from the muffler or tail pipe. Ten of the test strips with rectangular shape (3 mm x 40 mm) were excised respectively, by using a pair of stainless scissors, from the parts through which the exhaust emission passed or not. Then, 1 to 4 of the strips were inserted into per sample tube, and the tubes were subjected to ESR determination (JES - FA200 type, JEOL Ltd.). The conditions for the determination by ESR was the same as that in Example 2, and the TEMPOL at the above-mentioned concentration was used as the standard material.
Results are shown in Fig. 5. In Fig. 5, sample 1 is the result when one test strip is used for the determination, samples 2, 3 and 4 are those when two, three and four test strips were respectively used for the determination.
As shown in Fig. 5, the relative intensity of the carbon radical, the relative intensity obtained from ESR, increases in proportion to the numbers of the test strip used for the determination. Therefore, it is demonstrated that a certain concentration of carbon radicals are contained in the suspended particulate matter. Another determination separately done shows the same results.
Accordingly, it is demonstrated that the amounts of the carbon radical is determined by using ESR even through their concentration in the suspended particulate matter is very low, $10^{-13}$ spin/sample.
Further to GC or HPLC used for the determination of such substances, the treatment prior to the determination such as extraction by solvent is necessary when the organic compounds are adsorbed on the substance collected on the collection materials. The accuracy of the determination or the reproducibility depends on the treatment prior to the determination, for example, the effective ratio of extraction and so forth. However, in the determination by using ESR, both the substance adsorbed on the surface of the collection material and the substances sorbed in it may be determined without any treatment prior to the determination. Therefore, the accuracy of the determination is good, and the atoms or chemical species that cannot be detected or determined by using the conventional method may be determined in good sensitivity.

(EXAMPLE 3) Amounts of PM and SPM in the exhaust emission depending on the types of vehicles and fuels:

In order to study the amounts of PM and SPM in the exhaust emission depending on types of vehicles, exhaust emission is obtained according to the combinations as mentioned below.

(1) Types of vehicles and fuels used

The following vehicles were used: a truck of which capacity tonnage is 3 t produced by A company; two trucks of which capacity tonnage are respectively 2.5 t and 3.5 t produced by B company; a truck of which capacity tonnage is 2 t produced by C company; and a station wagon of which capacity tonnage is 1.25 t produced by D company.
For the station wagon of D company, gasoline from Kyodo Sekiyu K. K. is supplied, and the gas oil from Idemitsu Petrochemical Co. Ltd., Cosmo Oil Co., Ltd, Shell Sekiyu Inc., and Esso Inc., was supplied to the trucks described above.

(2) Preparation of sampling tubes

As the sampling tube for ESR determination, the tube shown in Fig. 1 made of glass was prepared: i. d. / o. d. of the body 8 mm/ 10 mm, the length of the body 15mm, i. d. of neck 6 mm, the entire length of the tube 43.5 mm. In the body of the tube, 100 mg of glass wool or cotton wool was uniformly packed to be a thickness of 5 mm.

(EXAMPLE 4) Determination of the suspended particulate matter in the exhaust emission from the type of vehicles:

The connection members were connected to the both ends of the sampling tube made in EXAMPLE 3(2), and the connection members were respectively connected to the metal tubes, which are made of stainless steel, and the size of it is 7 to 15 mm i.d., 500 to 600 mm length. One of the metal tubes was joined with the pump, and the other tube was inserted into a muffler or tail pipe so as to put the end of the tube at a position from about 25 cm from the end of the muffler or tail pipe. Then, the sampling is performed for 10 minutes.

Under the same determination condition as those in EXAMPLE 2, the amounts of the suspended particulate matter in the exhaust emission was determined by using ESR. Results are shown in Figs. 6 to 9. In Figs. 6 to 8, whole ESR spectrum was shifted to the direction for the lower magnetic field as indicated by an arrow positioned between 77.313 [mT] and 327.313 [mT]. The shift means that graphite carbon is probably generated. The deformation part of the curve as indicated by the arrow positioned between 327.313 [mT] and 577.313 [mT] was caused by the signal from the last determination.

As shown in Figs. 6 to 9, the spectra obtained were varied on the combination of types of vehicles and fuels. In the spectra from trucks produced by A company or B company, two kinds of radical derived from carbon were observed. Since g value of the ESR parameter, g was 2.268, and the line width $\Delta H$ was 109 mT, the broad signal shows that the graphite carbon was probably generated. As shown in Fig. 9, there was no the profile of the graphite carbon in the exhaust emission from the truck produced by C company so that it is supposed that the fuel was combusted very well.

The determination time per sample was about 2 minutes.

In Figs. 10 and 11, the results of ESR determination of the black powder deposited inside of the muffler or tail pipe and the suspended particulate matter in the exhaust emission from the station wagon produced by D company are shown. From these figures, the ESR spectra of them are well matched with each other, and it was demonstrated that the black powder deposited inside of the muffler or tail pipe was the same as the suspended particulate matter in the exhaust emission.

Furthermore, the spectra of Figs. 10 or 11 were completely different from those of Figs. 6 to 9. As seen from the shapes and positions of the peaks, it is supposed that iron ($Fe^{3+}$) and vanadium ($V^{2+}$, $V^{3+}$) were included in the emission gas. Since those are not originally contained or contained very little in gasoline, those may be derived from the damaged catalyst for the emission gas.

(EXAMPLE 5) Change of the amounts of PM on the sampling time:

The sampling tube prepared according to EXAMPLE 3 was set to a small cleaner for a private car, which is used by connecting a lighter for a cigarette, to perform the sampling the PM in the air for 1 hour at two points: one was at Kogo intersection of route 2, and another was a small intersection in the Gion 1-chome, Asaminami-ku, Hiroshima city. The sampling at the respective points was performed from 18:00 to 19:00, and 23:00 to 0:00.

After sampling, the sampling tubes were subjected to determination by using ESR, and investigated the change of the PM amounts and that of metal radicals detected. Results are shown in Figs. 12 to 14.

As clearly shown in Figs. 12 to 14, PM amounts collected between 18:00 to 19:00 were more than those collected between 23:00 to 0:00 at either point. Also the PM amounts collected at Kogo intersection of route 2, which has larger traffic flow, were more than those collected at the small intersection. Accordingly, it is confirmed that PM amounts are in proportion to traffic flow.

The amounts of heavy metals detected were also in proportion to the traffic flow. The heavy metals detected here were supposed to be iron, vanadium, manganese, and copper. In the figure, iron ($Fe^{+++}$), copper ($Cu^{++}$), and carbon radical (·C) were shown. ·$C_p$ represents the radical derived from graphite carbon.

These heavy metals are less contained in gas oil, and the catalyst in which divanadium pentaoxide is coated on the substrate such as iron is used as that for the emission gas is generally used. Therefore, it may be possible that the heavy metals are generated from such catalysts being damaged by some kind of the reason, and being adsorbed on the PM in the exhaust emission and discharged together with the emission gas.

## *INDUSTRIAL APPLICABILITY*

The present invention provides the method for determining the suspended particulate matter in the emission gas, conveniently, accurately and quickly. According to the determination method of the present invention, since ESR is employed as a measuring apparatus, solvents are not necessary and time for measuring the sample is short. Accordingly, the method of the present invention has the advantage that many samples can be determined accurately in short time.

## Claims

1. A method for determining particulate matter in a gas comprising the steps of:

   (1) passing the gas containing the particulate matter through a sampling tube to adsorb the particulate matter on a collection material,
   (2) determining the amounts of atoms or chemical species having an unpaired electron which are contained in the particulate matter adsorbed on said collection material by using electron spin resonance method, and
   (3) obtaining the amounts of the particulate matter in the gas based on the determined amounts of atoms or chemical species having the unpaired electron.

2. The method for determining the particulate matter according to claim 1, wherein the atom having the unpaired electron is selected from the group consisting of carbon, nitrogen, oxygen, sulfur, copper, iron, manganese, and vanadium atom.

3. The method for determining the particulate matter according to claim 1, wherein the chemical species having unpaired electron is radical containing a metallic element or the atom selected from the group consisting of carbon, nitrogen, oxygen, and sulfur.

4. The method for determining the particulate matter according to claim 1, wherein the radical containing the atom, which is selected from the group consisting of carbon, nitrogen, oxygen, and sulfur, is generated by heating and combusting a fossil fuel or wood.

5. A sampling tube for determining the particulate matter by using the electron spin resonance method, wherein said tube comprises a body having necks in both ends, of which diameters are smaller than that of the body, wherein an outer diameter of the body is 4 to 25 mm, that of the neck is 3 to 23 mm; the collection material, with its thickness (diameter) of 2 to 40 mm, is packed in the body, and a length of the tube is 4 to 200 mm.

6. The sampling tube for determining the particulate matter according to claim 5, wherein the tube is made of glass or plastic.

7. The sampling tube for determining the particulate matter according to claim 5, wherein the collection material is made of a material having adsorption ability or sorption ability.

8. The sampling tube for determining the particulate matter according to claim 7, wherein said material having adsorption ability or sorption ability is selected from the group consisting of paper, woven and non-woven fabrics, cellulose, glass wool, and cotton wool.

9. A sampling kit for determining the particulate matter in the gas comprising the sampling tube according to any one of claims 5 to 8, and a connection member connecting the sampling tube to tubes introducing the gas of interest into the tube.

10. A sampling kit for determining the particulate matter comprising the sampling tube according to claim 9, wherein the kit comprises at least two connection members and at least two sampling tubes.

11. A sampling kit for determining the particulate matter comprising the sampling tube according to claim 9; wherein said connection member is made of heat resistant elastomer.

12. A sampling kit for determining the particulate matter in the gas comprising the sampling tube according to claim 11, wherein the elastomer is selected from the group consisting of silicone rubber, acrylic rubber, ethylene-propylene rubber, chloroprene rubber, styrene-butadiene rubber and butyl rubber.

13. A sampling kit for determining the particulate matter according to claim 9, further comprising a container to house the sampling tube and the connection member.

*Fig. 1*

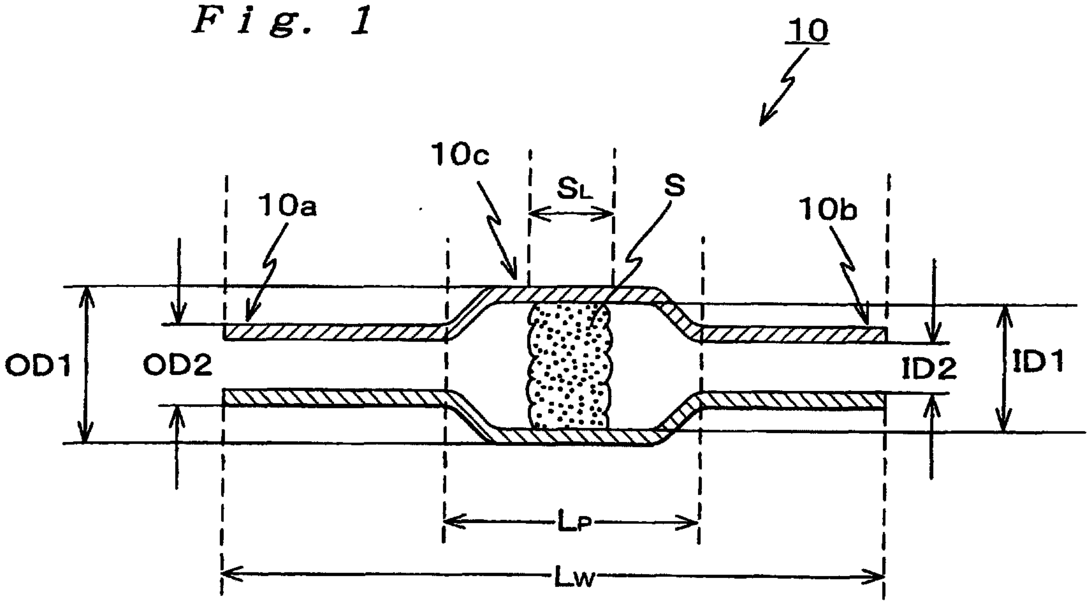


*Fig. 2*

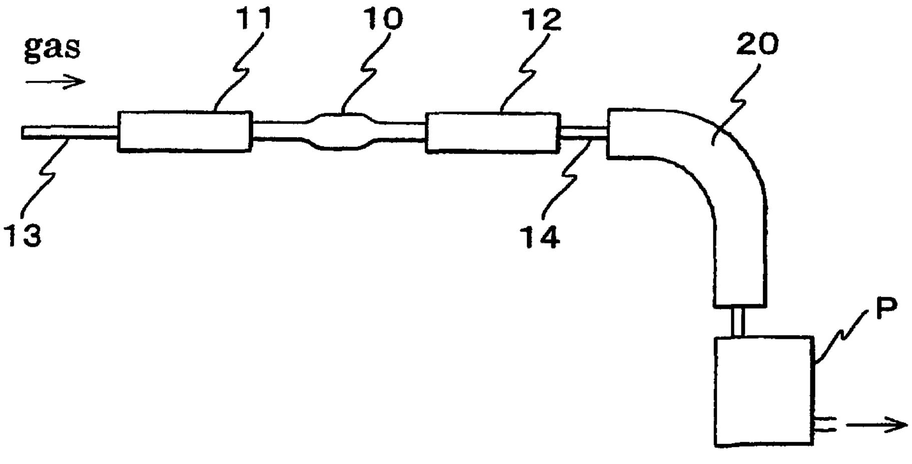

*Fig. 3*

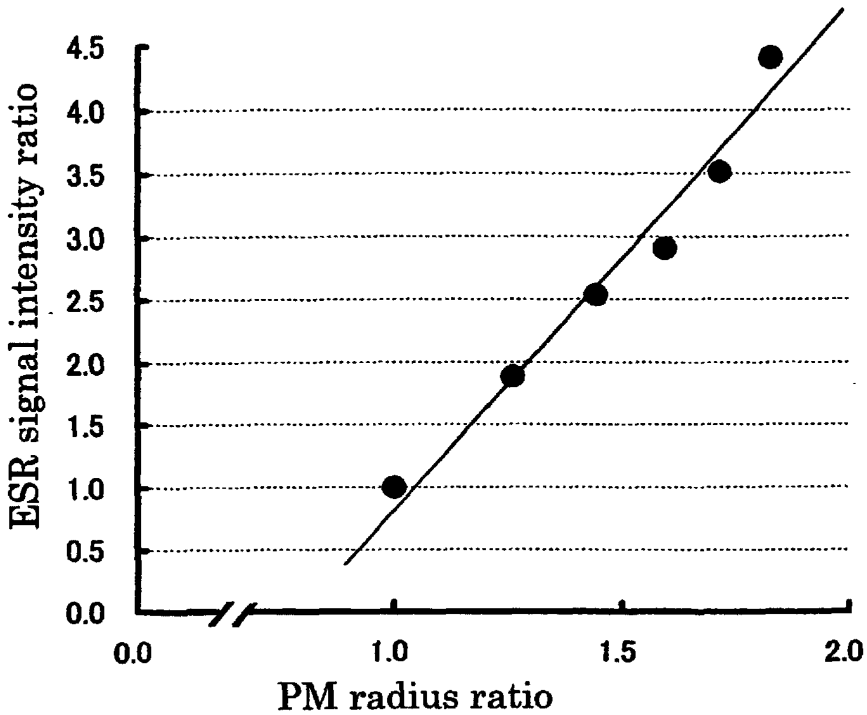
ESR signal intensity ratio
4.5
4.0
3.5
3.0
2.5
2.0
1.5
1.0
0.5
0.0
0.0
1.0
1.5
2.0
PM radius ratio

Fig. 4

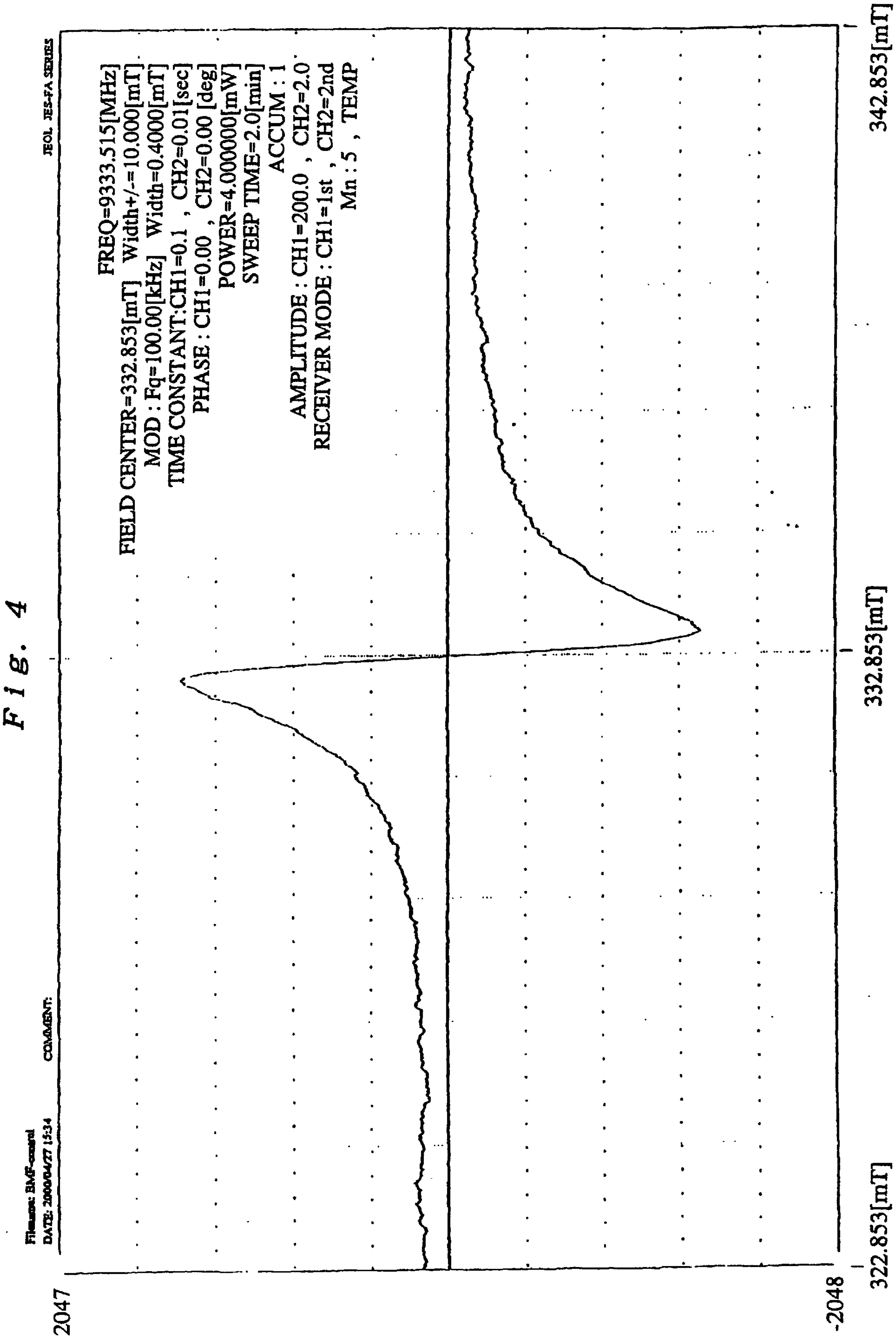
FREQ=9333.515[MHz]
FIELD CENTER=332.853[mT] Width+/-=10.000[mT]
MOD : Fq=100.00[kHz] Width=0.4000[mT]
TIME CONSTANT:CH1=0.1 , CH2=0.01[sec]
PHASE : CH1=0.00 , CH2=0.00 [deg]
POWER=4.000000[mW]
SWEEP TIME=2.0[min]
ACCUM : 1
AMPLITUDE : CH1=200.0 , CH2=2.0
RECEIVER MODE : CH1=1st , CH2=2nd
Mn : 5 , TEMP
JEOL JES-FA SERIES
COMMENT:
2047
-2048
322.853[mT]
332.853[mT]
342.853[mT]

*Fig. 5*

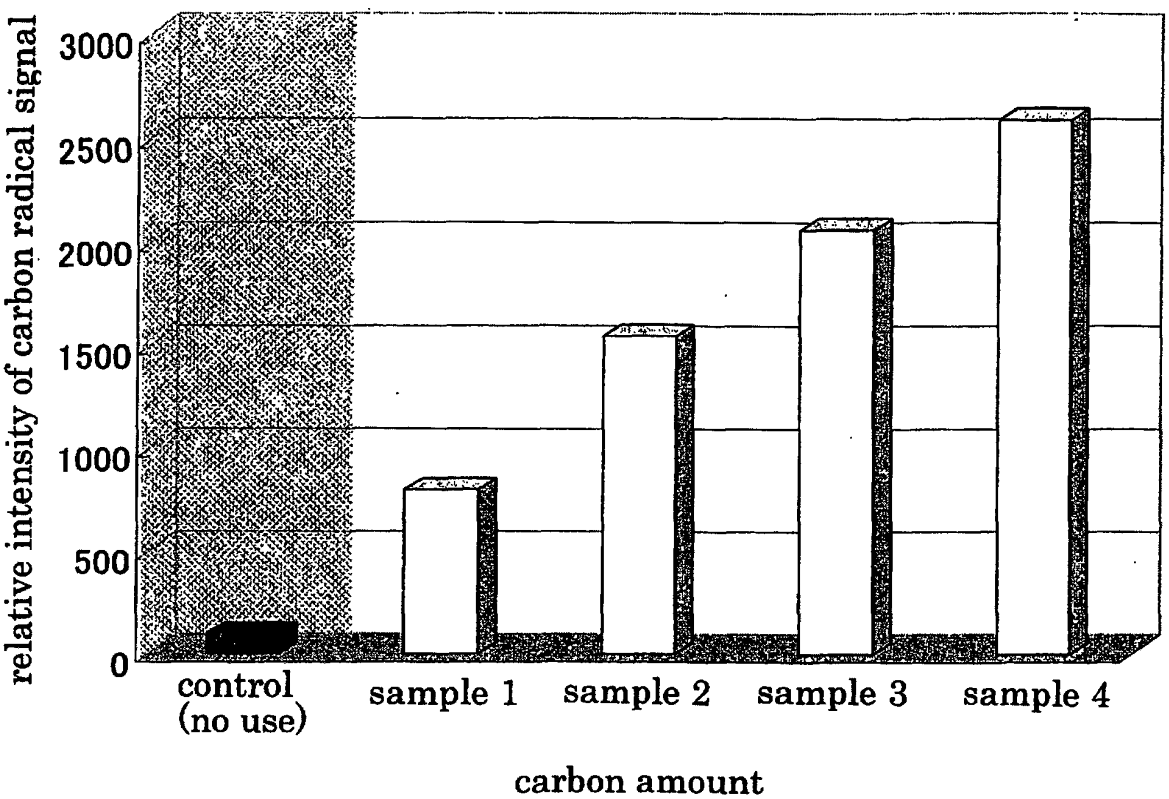
relative intensity of carbon radical signal
3000
2500
2000
1500
1000
500
0
control
(no use)
sample 1
sample 2
sample 3
sample 4
carbon amount

*Fig. 6*

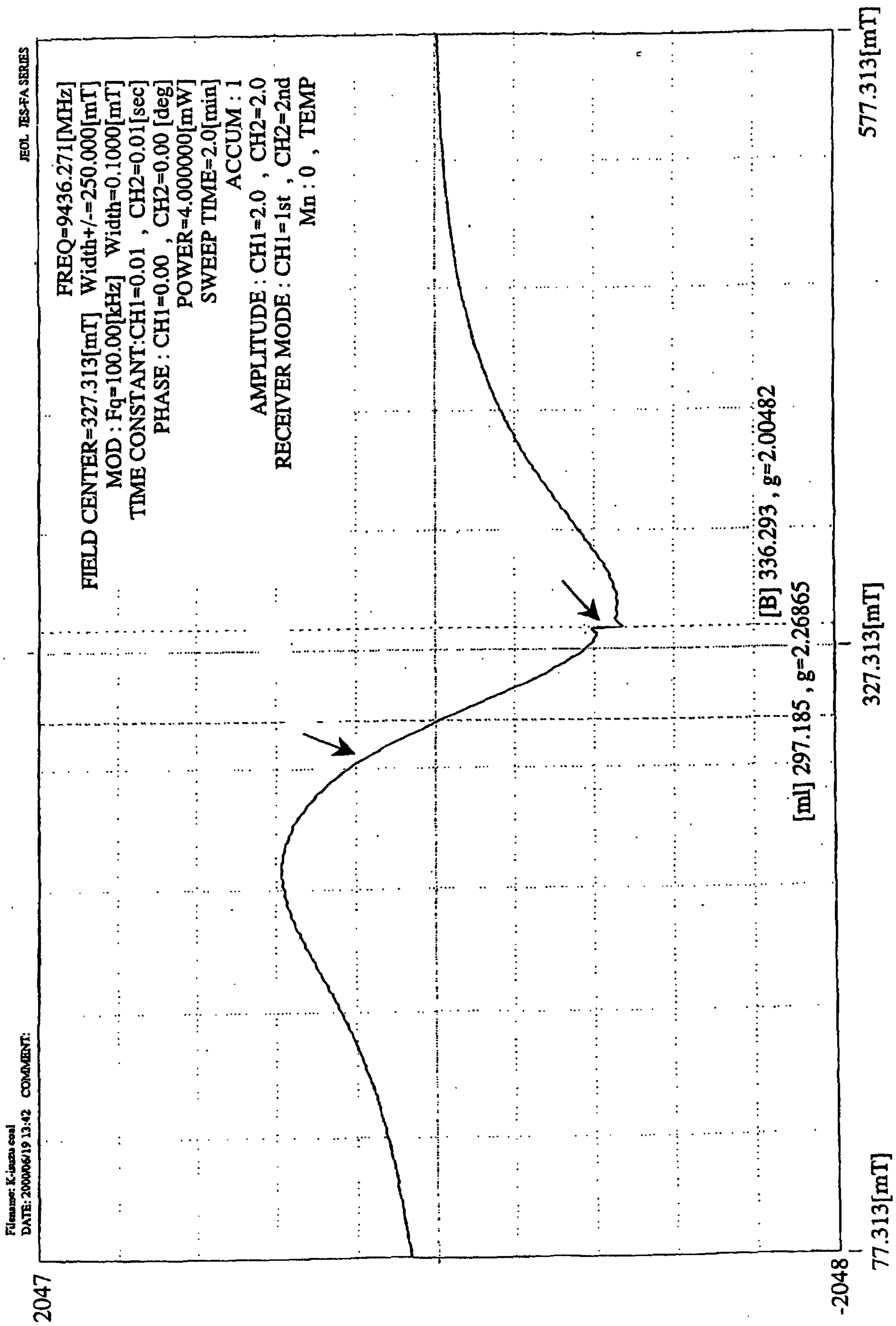
DATE: 2000/06/19 13:42 COMMENT:
JEOL JES-FA SERIES
FREQ=9436.271[MHz]
FIELD CENTER=327.313[mT] Width+/-=250.000[mT]
MOD : Fq=100.00[kHz] Width=0.1000[mT]
TIME CONSTANT:CH1=0.01 , CH2=0.01[sec]
PHASE : CH1=0.00 , CH2=0.00 [deg]
POWER=4.000000[mW]
SWEEP TIME=2.0[min]
ACCUM : 1
AMPLITUDE : CH1=2.0 , CH2=2.0
RECEIVER MODE : CH1=1st , CH2=2nd
Mn : 0 , TEMP
[B] 336.293 , g=2.00482
[ml] 297.185 , g=2.26865
2047
-2048
77.313[mT]
327.313[mT]
577.313[mT]

*F i g . 7*

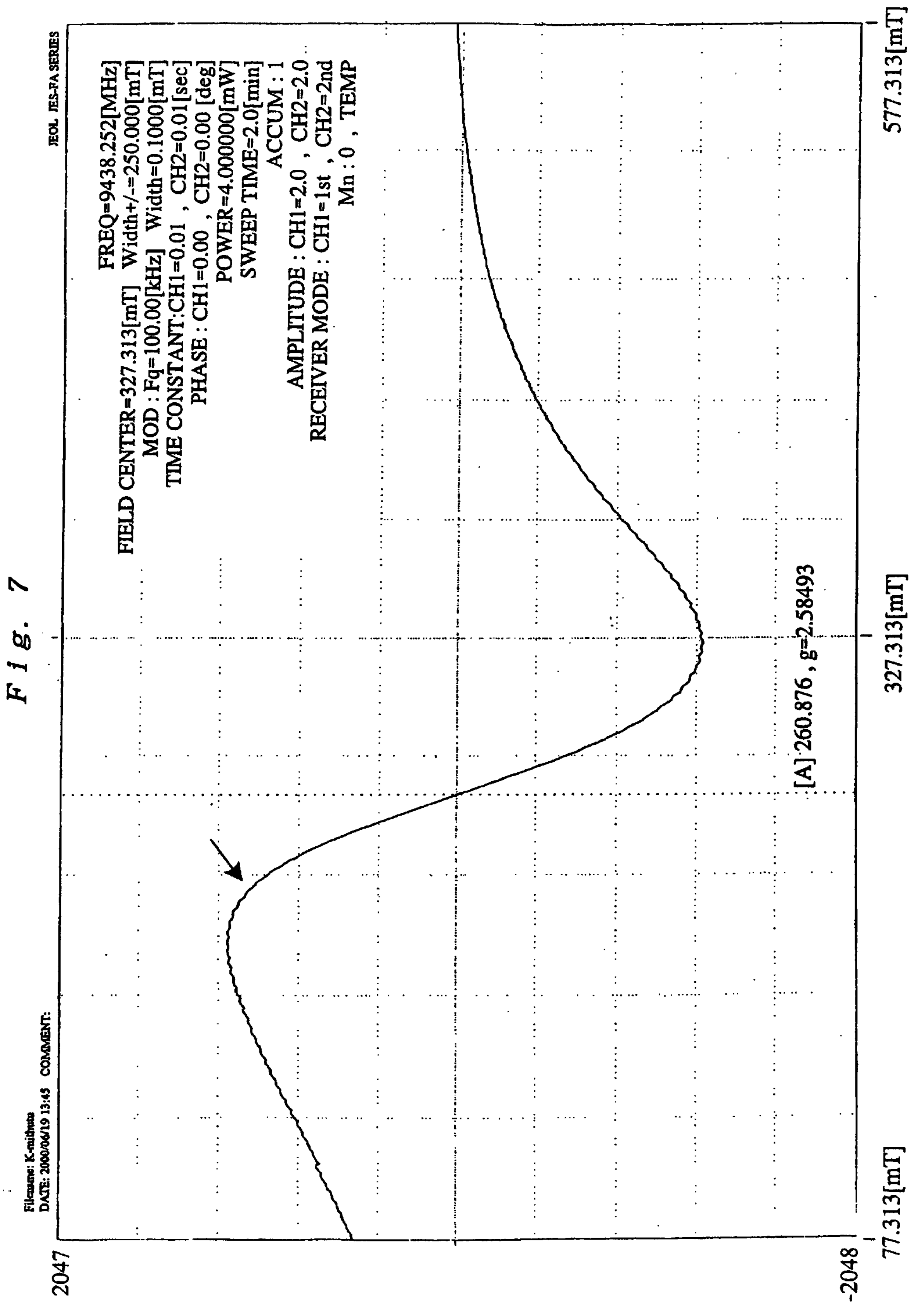
Filename: K-mitsuta
DATE: 2000/06/19 13:45 COMMENT:
JEOL JES-FA SERIES
FIELD CENTER=327.313[mT] FREQ=9438.252[MHz]
Width+/-=250.000[mT]
MOD : Fq=100.00[kHz] Width=0.1000[mT]
TIME CONSTANT:CH1=0.01 , CH2=0.01[sec]
PHASE : CH1=0.00 , CH2=0.00 [deg]
POWER=4.000000[mW]
SWEEP TIME=2.0[min]
ACCUM : 1
AMPLITUDE : CH1=2.0 , CH2=2.0
RECEIVER MODE : CH1=1st , CH2=2nd
Mn : 0 , TEMP
[A] 260.876 , g=2.58493
2047
-2048
77.313[mT]
327.313[mT]
577.313[mT]

Fig. 8

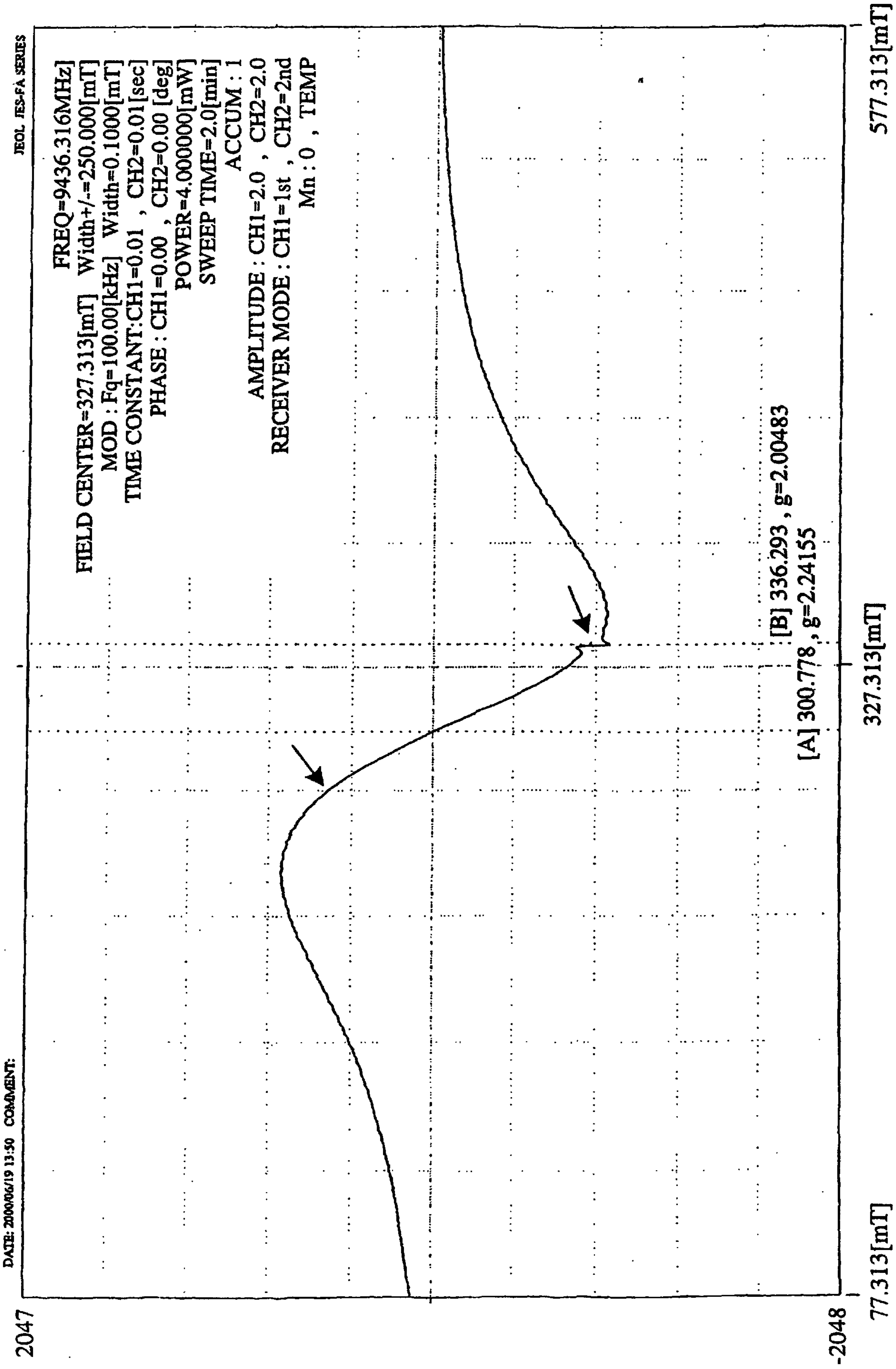
JEOL JES-FA SERIES
FREQ=9436.316MHz
FIELD CENTER=327.313[mT] Width+/-=250.000[mT]
MOD : Fq=100.00[kHz] Width=0.1000[mT]
TIME CONSTANT:CH1=0.01 , CH2=0.01[sec]
PHASE : CH1=0.00 , CH2=0.00 [deg]
POWER=4.000000[mW]
SWEEP TIME=2.0[min]
ACCUM : 1
AMPLITUDE : CH1=2.0 , CH2=2.0
RECEIVER MODE : CH1=1st , CH2=2nd
Mn : 0 , TEMP
[A] 300.778 , g=2.24155
[B] 336.293 , g=2.00483
2047
-2048
77.313[mT]
327.313[mT]
577.313[mT]

*Fig. 9*

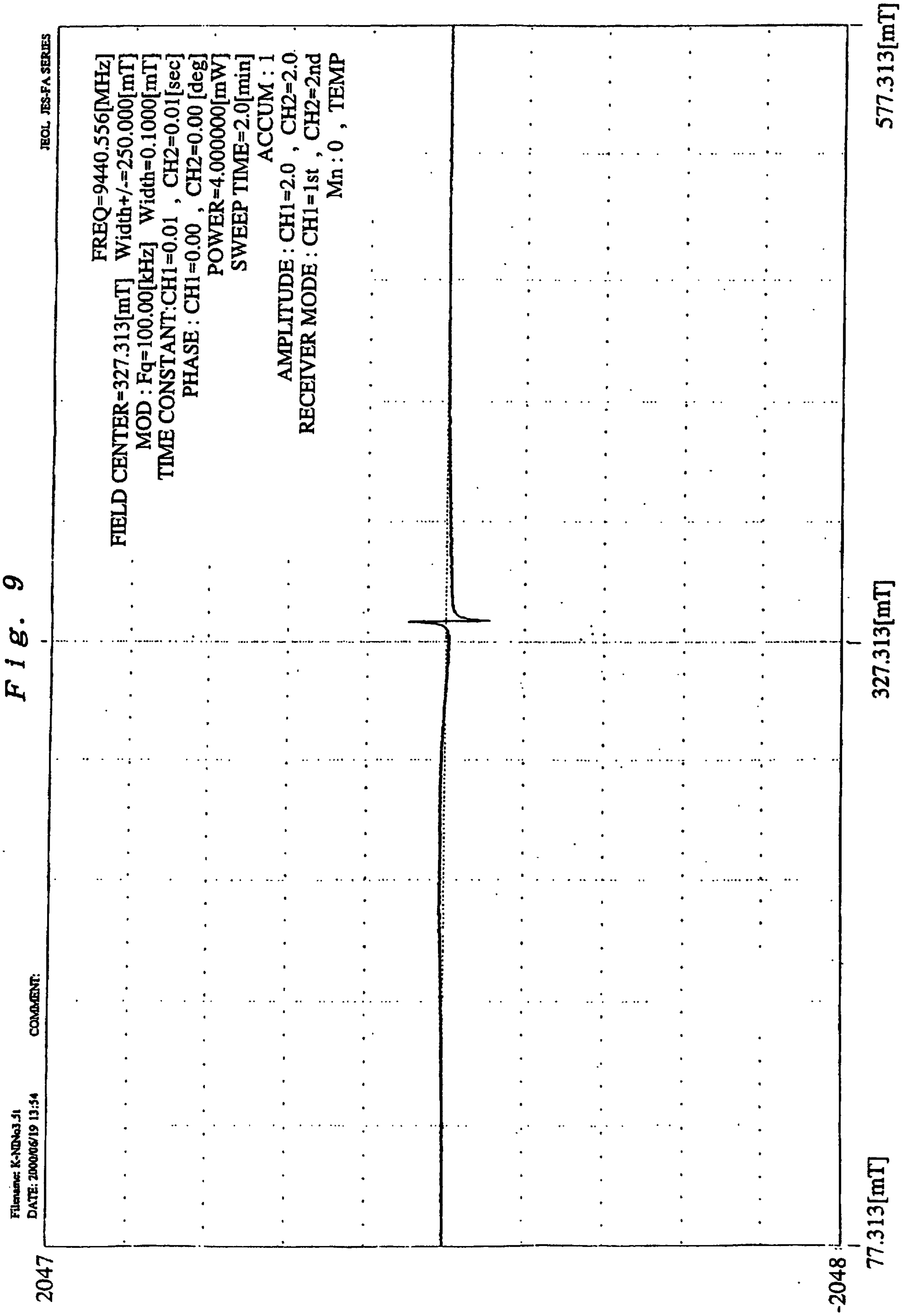
Filename: K-NiNo3.51
DATE: 2000/06/19 13:54
COMMENT:
JEOL JES-FA SERIES
FIELD CENTER=327.313[mT] Width+/-=250.000[mT]
FREQ=9440.556[MHz]
MOD : Fq=100.00[kHz] Width=0.1000[mT]
TIME CONSTANT:CH1=0.01 , CH2=0.01[sec]
PHASE : CH1=0.00 , CH2=0.00 [deg]
POWER=4.000000[mW]
SWEEP TIME=2.0[min]
ACCUM : 1
AMPLITUDE : CH1=2.0 , CH2=2.0
RECEIVER MODE : CH1=1st , CH2=2nd
Mn : 0 , TEMP
2047
-2048
77.313[mT]
327.313[mT]
577.313[mT]

Fig. 10

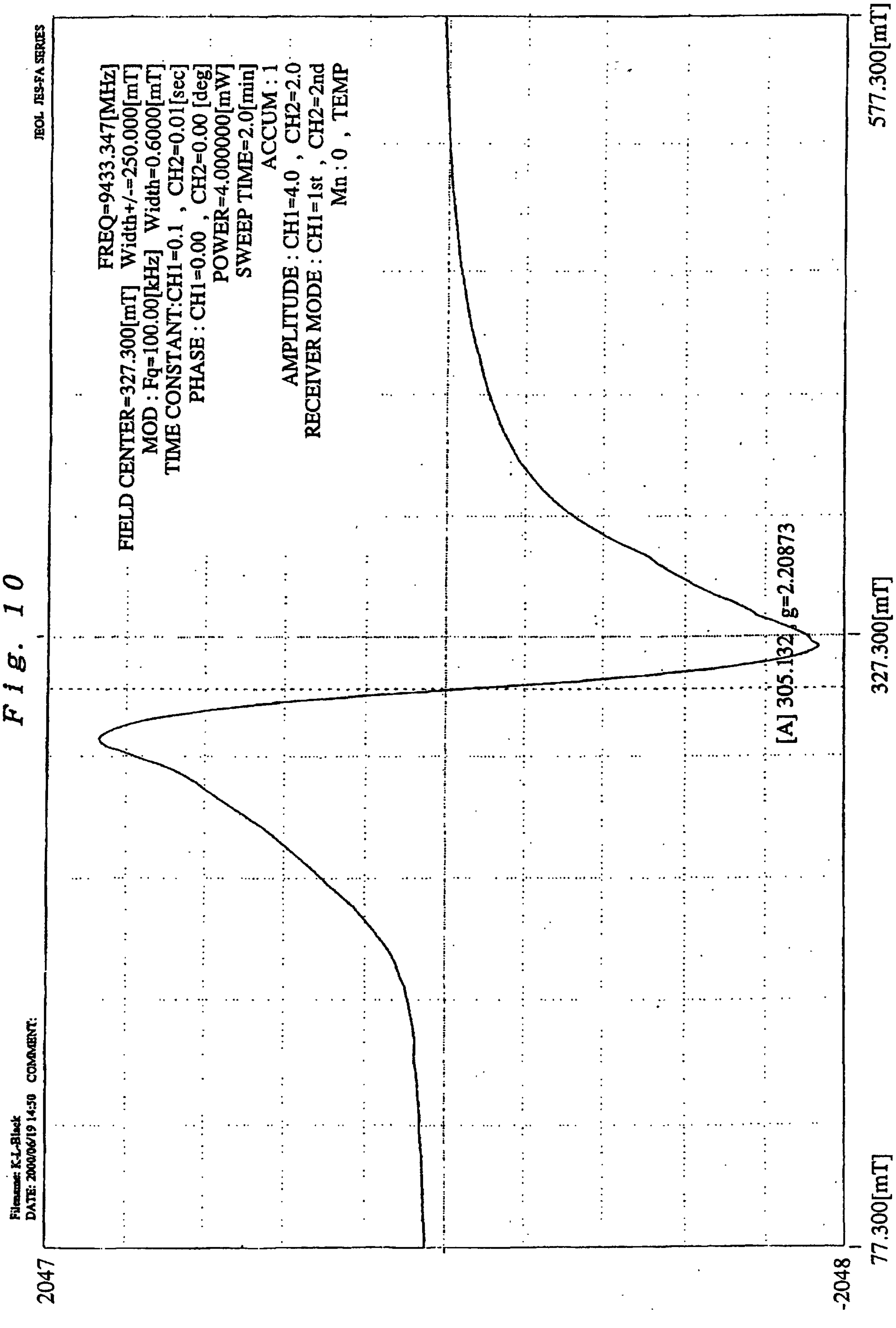

JEOL JES-FA SERIES
FREQ=9433.347[MHz]
FIELD CENTER=327.300[mT] Width+/-=250.000[mT]
MOD : Fq=100.00[kHz] Width=0.6000[mT]
TIME CONSTANT:CH1=0.1 , CH2=0.01[sec]
PHASE : CH1=0.00 , CH2=0.00 [deg]
POWER=4.0000000[mW]
SWEEP TIME=2.0[min]
ACCUM : 1
AMPLITUDE : CH1=4.0 , CH2=2.0
RECEIVER MODE : CH1=1st , CH2=2nd
Mn : 0 , TEMP
Filename: K-L-Black
DATE: 2000/06/19 14:50 COMMENT:
[A] 305.132 g=2.20873
2047
-2048
77.300[mT]
327.300[mT]
577.300[mT]

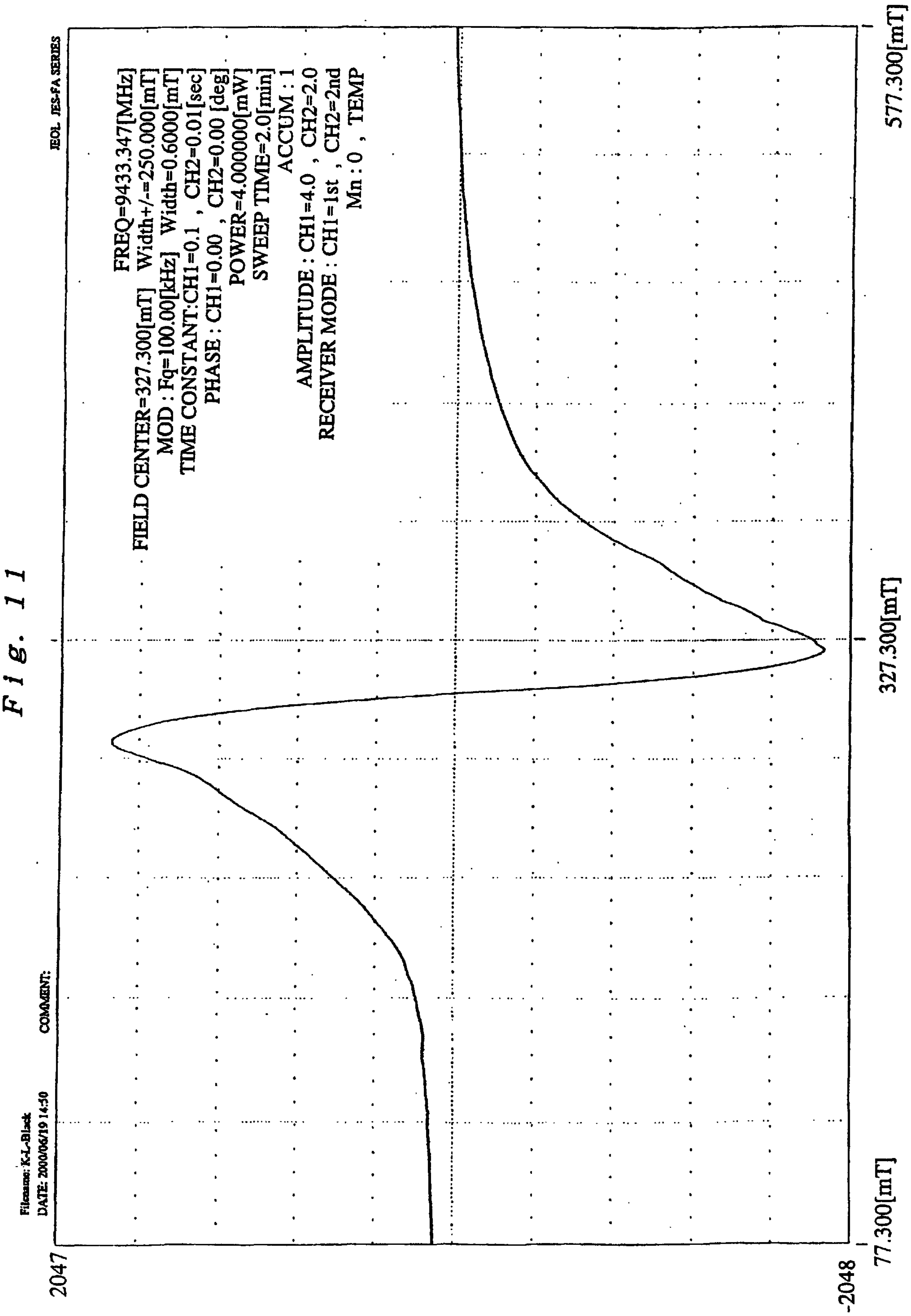
Filename: K-L-Black
DATE: 2000/06/19 14:50
COMMENT:
JEOL JES-FA SERIES
FIELD CENTER=327.300[mT]
FREQ=9433.347[MHz]
Width+/-=250.000[mT]
MOD : Fq=100.00[kHz] Width=0.6000[mT]
TIME CONSTANT:CH1=0.1 , CH2=0.01[sec]
PHASE : CH1=0.00 , CH2=0.00 [deg]
POWER=4.000000[mW]
SWEEP TIME=2.0[min]
ACCUM : 1
AMPLITUDE : CH1=4.0 , CH2=2.0
RECEIVER MODE : CH1=1st , CH2=2nd
Mn : 0 , TEMP
2047
-2048
77.300[mT]
327.300[mT]
577.300[mT]

Fig. 11

*Fig. 12*

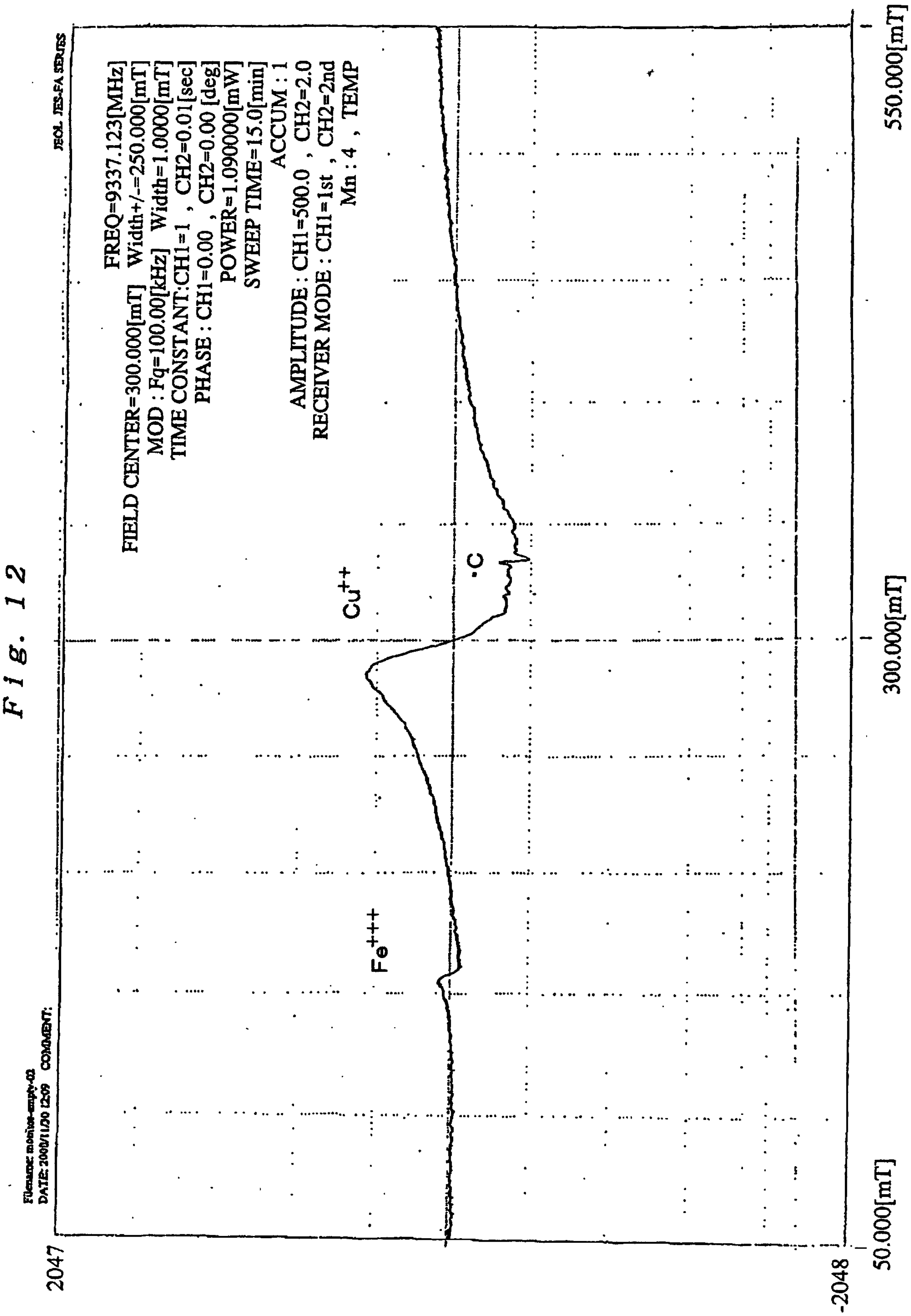

FREQ=9337.123[MHz]
FIELD CENTER=300.000[mT] Width+/-=250.000[mT]
MOD : Fq=100.00[kHz] Width=1.0000[mT]
TIME CONSTANT:CH1=1 , CH2=0.01[sec]
PHASE : CH1=0.00 , CH2=0.00 [deg]
POWER=1.090000[mW]
SWEEP TIME=15.0[min]
ACCUM : 1
AMPLITUDE : CH1=500.0 , CH2=2.0
RECEIVER MODE : CH1=1st , CH2=2nd
Mn : 4 , TEMP
JEOL JES-FA SERIES
COMMENT:
Cu++
·C
Fe+++
2047
-2048
50.000[mT]
300.000[mT]
550.000[mT]

*Fig. 13*

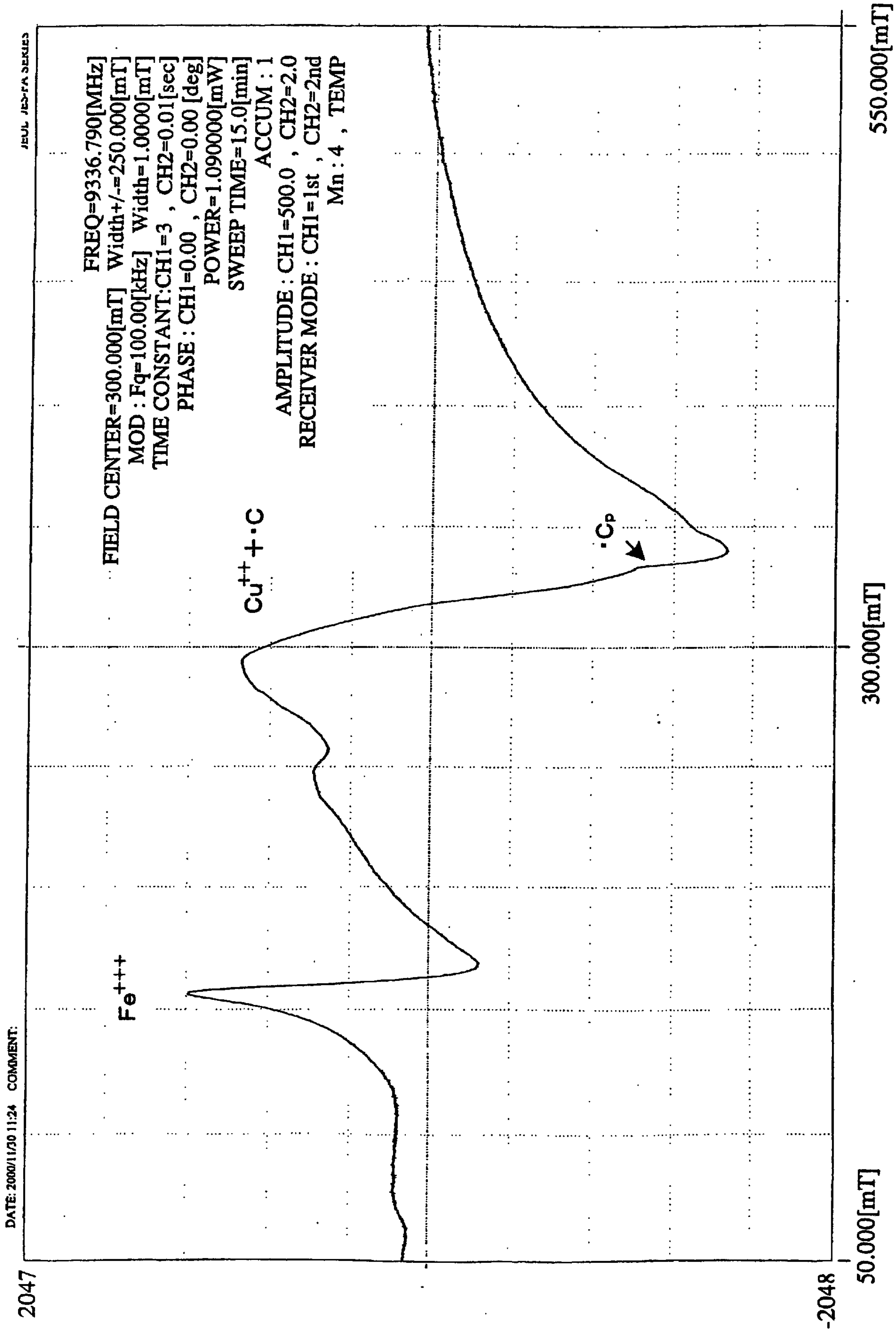
DATE: 2000/11/30 11:24 COMMENT:
JEOL JES-FA SERIES
FIELD CENTER=300.000[mT]
FREQ=9336.790[MHz]
Width+/-=250.000[mT]
MOD : Fq=100.00[kHz] Width=1.0000[mT]
TIME CONSTANT:CH1=3 , CH2=0.01[sec]
PHASE : CH1=0.00 , CH2=0.00 [deg]
POWER=1.090000[mW]
SWEEP TIME=15.0[min]
ACCUM : 1
AMPLITUDE : CH1=500.0 , CH2=2.0
RECEIVER MODE : CH1=1st , CH2=2nd
Mn : 4 , TEMP
$Fe^{+++}$
$Cu^{++}$ + ·C
·$C_p$
2047
-2048
50.000[mT]
300.000[mT]
550.000[mT]

*Fig. 14*

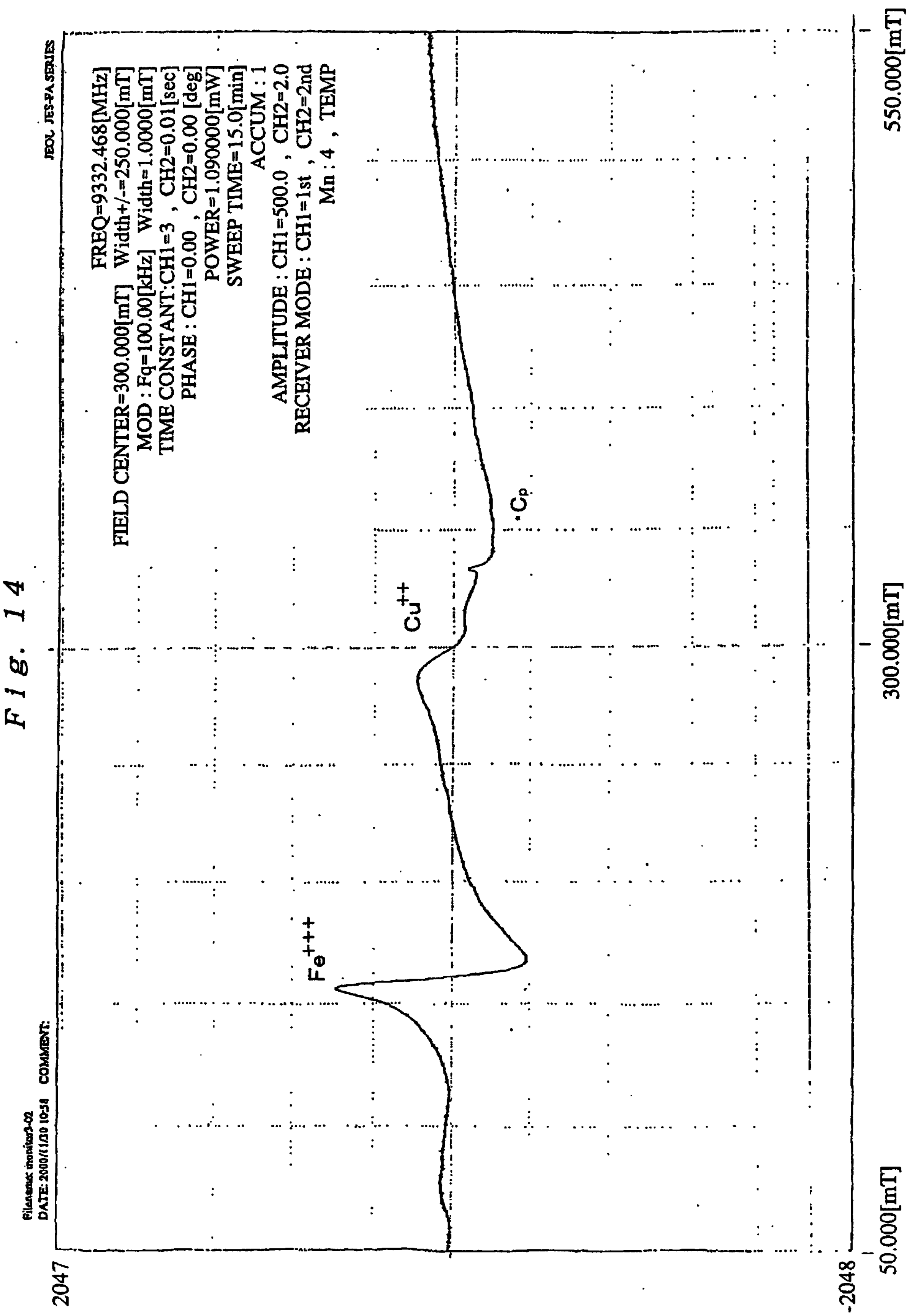
JEOL JES-FA SERIES
COMMENT:
FREQ=9332.468[MHz]
FIELD CENTER=300.000[mT] Width+/-=250.000[mT]
MOD : Fq=100.00[kHz] Width=1.0000[mT]
TIME CONSTANT:CH1=3 , CH2=0.01[sec]
PHASE : CH1=0.00 , CH2=0.00 [deg]
POWER=1.090000[mW]
SWEEP TIME=15.0[min]
ACCUM : 1
AMPLITUDE : CH1=500.0 , CH2=2.0
RECEIVER MODE : CH1=1st , CH2=2nd
Mn : 4 , TEMP
$Fe^{+++}$
$Cu^{++}$
$\cdot C_p$
2047
-2048
50.000[mT]
300.000[mT]
550.000[mT]

# INTERNATIONAL SEARCH REPORT

International application No.
PCT/JP01/04506

A. CLASSIFICATION OF SUBJECT MATTER
Int.Cl[7] G01N24/10, G01N1/02

According to International Patent Classification (IPC) or to both national classification and IPC

B. FIELDS SEARCHED

Minimum documentation searched (classification system followed by classification symbols)
Int.Cl[7] G01N24/00-24/14, G01R33/20-33/64, G01N1/00-1/26

Documentation searched other than minimum documentation to the extent that such documents are included in the fields searched

| | | | |
|---|---|---|---|
| Jitsuyo Shinan Koho | 1992-1996 | Toroku Jitsuyo Shinan Koho | 1994-2001 |
| Kokai Jitsuyo Shinan Koho | 1971-2001 | Jitsuyo Shinan Toroku Koho | 1996-2001 |

Electronic data base consulted during the international search (name of data base and, where practicable, search terms used)
JICST FILE (JOIS)

C. DOCUMENTS CONSIDERED TO BE RELEVANT

| Category* | Citation of document, with indication, where appropriate, of the relevant passages | Relevant to claim No. |
|---|---|---|
| A | JP, 49-15489, A (Sagami Chemical Research Center), 09 February, 1974 (09.02.74), Full text; Figs. 1 to 6 & DE, 2325053, A & FR, 2185334, A & GB, 1366235, A | 1-13 |
| A | Environment International, Vol.7, No.5, (1982), M. M. Ross et al., "Electron paramagnetic resonance spectrometry of diesel particulate matter", pages 325 to 329 | 1-13 |
| A | Water Science & Technology, Vol.27, No.7-8, (1993), B. Iosefzon-Kuyavskaya et al., "ESR indication of heavy metal contamination of urban atmosphere", pages 263 to 269 | 1-13 |

☐ Further documents are listed in the continuation of Box C. ☐ See patent family annex.

* Special categories of cited documents:
"A" document defining the general state of the art which is not considered to be of particular relevance
"E" earlier document but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>13 June, 2001 (13.06.01) | Date of mailing of the international search report<br>26 June, 2001 (26.06.01) |
| Name and mailing address of the ISA/<br>Japanese Patent Office<br><br>Facsimile No. | Authorized officer<br><br>Telephone No. |

Form PCT/ISA/210 (second sheet) (July 1992)